# EUROPÄISCHE PATENTSCHRIFT

(11) **EP 4 163 847 B1**
(45) Veröffentlichungstag und Bekanntmachung des Hinweises auf die Patenterteilung: **31.01.2024**
(21) Anmeldenummer: 22211887.9
(22) Anmeldetag: 06.08.2019
(51) Int. Cl.: G06Q 10/08

(54) **ERMITTLUNG EINES ODER MEHRERER KENNWERTE SOWIE SIMULATION VON VERKEHR FÜR EINE AUTOMATISCH BEFAHRBARE UMGEBUNG**
DETERMINATION OF ONE OR MORE CHARACTERISTIC VALUES AND SIMULATION OF TRAFFIC FOR AN AUTOMATICALLY DRIVABLE ENVIRONMENT
DÉTERMINATION D'UNE OU PLUSIEURS CARACTÉRISTIQUES AINSI QUE SIMULATION DE TRAFIC POUR UN ENVIRONNEMENT POUVANT ÊTRE MIS À L'ÉCHELLE AUTOMATIQUEMENT

(30) Priorität: 09.08.2018 DE 102018119397
(43) Veröffentlichungstag der Anmeldung: 12.04.2023
(62) Teilanmeldung aus: 19190343.4
(73) Patentinhaber: SICK AG, 79183 Waldkirch (DE)
(72) Erfinder: Fuerstenberg, Kay, 79111 Freiburg (DE); Reinke, Christoph, 22143 Hamburg (DE); Beinschob, Patric, 22043 Hamburg (DE); Hansen, Christoph, 20535 Hamburg (DE); Plasberg, Georg, 79353 Bahlingen am Kaiserstuhl (DE); Wüstefeld, Martin, 79350 Sexau (DE)
(74) Vertreter: Manitz Finsterwald Patent- und Rechtsanwaltspartnerschaft mbB

(56) Entgegenhaltungen:
- KELEN C T VIVALDINI ET AL: "Robotic forklifts for intelligent warehouses: Routing, path planning, and auto-localization", INDUSTRIAL TECHNOLOGY (ICIT), 2010 IEEE INTERNATIONAL CONFERENCE ON, IEEE, PISCATAWAY, NJ, USA, 14. März 2010 (2010-03-14), Seiten 1463-1468, XP031680952, ISBN: 978-1-4244-5695-6
- ALEXEY DOSOVITSKIY ET AL: "CARLA: An Open Urban Driving Simulator", ARXIV.ORG, CORNELL UNIVERSITY LIBRARY, 201 OLIN LIBRARY CORNELL UNIVERSITY ITHACA, NY 14853, 10. November 2017 (2017-11-10), XP081287280,
- HENDRICKSON CHRIS ET AL: "Traffic Simulation and Transportation Engineering", JOURNAL OF TRANSPORTATION ENGINEERING, PART A: SYSTEMS, Bd. 143, Nr. 12, 1. Dezember 2017 (2017-12-01), XP093027065, ISSN: 2473-2907, DOI: 10.1061/JTEPBS.0000091
- DAMJAN MIKLIC ET AL: "A modular control system for warehouse automation - algorithms and simulations in USARSim", ROBOTICS AND AUTOMATION (ICRA), 2012 IEEE INTERNATIONAL CONFERENCE ON, IEEE, 14. Mai 2012 (2012-05-14), Seiten 3449-3454, XP032450625, DOI: 10.1109/ICRA.2012.6224894 ISBN: 978-1-4673-1403-9
- DAMJAN MIKLIC ET AL: "A control architecture for warehouse automation - Performance evaluation in USARSim", ROBOTICS AND AUTOMATION (ICRA), 2011 IEEE INTERNATIONAL CONFERENCE ON, IEEE, 9. Mai 2011 (2011-05-09), Seiten 109-114, XP032033835, DOI: 10.1109/ICRA.2011.5979972 ISBN: 978-1-61284-386-5
- GERKEY B P ET AL: "The player/stage project : tools for multi robot and distributed sensor systems", PROCEEDINGS OF THE 11TH INTERNATIONAL CONFERENCE ON ADVANCED ROBOTICS : JUNE 30 - JULY 3, 2003, UNIVERSITY OF COIMBRA, COIMBRA, PORTUGAL,, 1. Januar 2003 (2003-01-01), Seiten 317-323, XP009163748,
- ELSAYED A. ORADY ET AL: "Virtual reality software for robotics and manufacturing cell simulation", COMPUTERS & INDUSTRIAL ENGINEERING, Bd. 33, Nr. 1-2, 1. Oktober 1997 (1997-10-01), Seiten 87-90, XP055641575, AMSTERDAM, NL ISSN: 0360-8352, DOI: 10.1016/S0360-8352(97)00047-8

## Beschreibung

Die Erfindung betrifft ein Verfahren und eine Vorrichtung zur Ermittlung eines oder Fahrzeugparameter für autonom fahrende Fahrzeuge für eine automatisch mit Fahrzeugen befahrbare Umgebung.

Als Beispiel für eine solche Umgebung kann man sich ein Lager denken, innerhalb dessen fahrerlose Fahrzeuge Lagergut transportieren, aufnehmen, ablegen, umschichten und in das Lager hinein bzw. aus ihm heraus bringen. Der Transport kann vorrangig in der Ebene (vorzugsweise horizontal und eben, als x-y-Ebene angenommen) erfolgen, aber kann auch vertikal (z-Richtung) erfolgen, etwa mittels eines automatischen Gabelstaplers oder ähnlichem. Solche Liegenschaften können vergleichsweise groß sein und viele 1.000 bis einige 10.000 Quadratmeter Grundfläche haben. In ihnen können viele automatisch fahrende Fahrzeuge unterwegs sein. Neben automatisch fahrenden Fahrzeugen können darin auch konventionell von Menschen geführte Fahrzeuge vorhanden sein und auch Fußgänger.

Als weiteres Beispiel kann man sich die Bewegung eines Roboters oder Roboterarms in einer Umgebung denken. Der Roboterarm ist dann das Fahrzeug, und die Umgebung weist verschiedene andere Objekte auf, etwa ein zu fertigendes Produkt, ein Kleinwarenlager, einen anderen (beweglichen) Roboterarm, eine oder mehrere Personen, sonstige stationäre oder bewegliche Hindernisse und ähnliches.

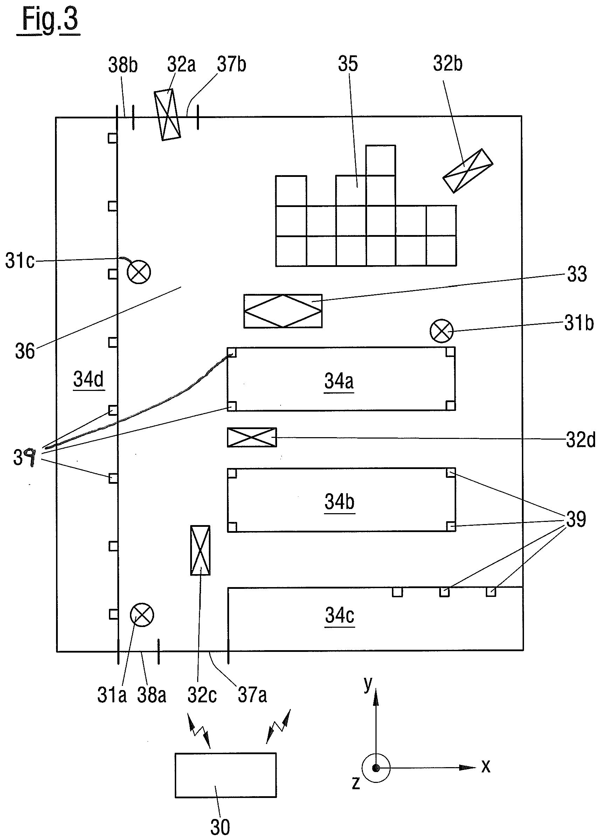

Fig. 3 zeigt schematisch eine mögliche Konstellation in Draufsicht. Angenommen ist ein Lagerraum mit einer befahrbaren Fläche 36. Mit 37a und 37b sind durchfahrbare Tore angedeutet. Mit 38a und 38b sind Türen für Personen angedeutet. Strukturen 34a, 34b, 34c und 34d sind stationäre Regale zur Lagerung von Gütern. 35 deutet ein Freilager an, also Flächen, auf denen Güter frei abgelegt werden können und die entsprechend dem Belegungszustand befahrbar oder nicht befahrbar sind. Mit 39 sind aktive und/oder passive Navigationshilfen bezeichnet, die der Navigation und der Orientierung der automatisch fahrenden Fahrzeuge 32 dienen. Es kann sich um passive Reflektoren zur optischen Erfassung handeln oder um aktive Sensoren, die zwei- oder dreidimensional die Umgebung erfassen können und ihre Erfassungsergebnisse an einen Zentralrechner 30 drahtlos oder leitungsgebunden übertragen können. Dieser Rechner 30 steht wiederum mit den automatisch fahrenden Fahrzeugen 32 in Verbindung. Statt über einen Zentralrechner 30 kann die Kommunikation zwischen Navigationshilfen 39 und automatischen Fahrzeugen 32 aber auch direkt drahtlos geschehen. Passive Navigationshilfen können an Hindernissen (beispielsweise an Regalen 34) angebracht sein oder können auch befahrbare Markierungen auf dem Boden sein.

Fig. 3 zeigt vier automatisch fahrende Fahrzeuge 32a, 32b, 32c und 32d. Mit 33 ist ein konventionell von einem Menschen geführtes Fahrzeug bezeichnet, etwa ein Gabelstapler oder ein Fahrrad oder ähnliches. Mit 31a-c sind schließlich Personen gekennzeichnet, die sich im Lager aufhalten können.

Die automatisch fahrenden Fahrzeuge 32 bringen Waren von außen in das Lager und legen sie dort in einem Regal 34 oder auf der Freifläche 35 ab, und/oder nehmen Waren von dort auf und bringen sie aus dem Lager heraus, und/oder führen Umschichtungen innerhalb des Lagers oder schlichte Durchfahrten durch.

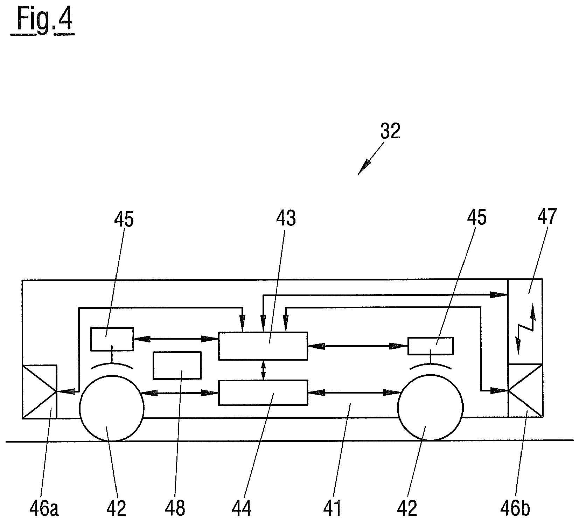

Um automatisch fahren zu können, sind die Fahrzeuge 32 mit diversen Sensoren und anderen Steuerungseinrichtungen ausgestattet. Fig. 4 zeigt dies systematisch. Mit 43 ist dort eine zentrale Steuerung angedeutet, die von Sensorik 46a, 46b Signale empfängt und diese an die Aktorik 44, 45 abgibt. Darüber hinaus steht die Steuerung 43 mit einer Drahtloskommunikationsverbindung 47 in Verbindung, mittels derer sie mit anderen Fahrzeugen oder mit einem Zentralrechner 30 kommunizieren kann. Die Aktorik kann den Fahrzeugantrieb 44 aufweisen und/oder Bremsen 45 und/oder Lenkung und dergleichen. Die Sensorik kann interne Sensorik aufweisen (Geschwindigkeitssensor, Beschleunigungssensor, ...) und Umgebungssensorik, die zwei- oder dreidimensional die Umgebung um das Fahrzeug herum abtasten und erfassen kann.

Bei der beschriebenen Umgebungssensorik kann es sich um eine ortsauflösende Abstandssensorik handeln, die etwa mittels LIDAR (Light Detection and Ranging) oder LADAR (Laser Detection and Ranging) oder mit RADAR die Umgebung insoweit erfassbar macht, als die Ortsauflösung dieser Sensorik vergleichsweise fein sein kann und im Bereich eines Zentimeters oder weniger Zentimeter liegen. Üblicherweise sind mehrere dieser Umgebungssensoren vorgesehen, um einerseits die Umgebung des Fahrzeugs vollständig erfassen zu können und um andererseits Redundanzen zu haben für den Fall, dass einer der Sensoren ausfällt, und für Crosschecks.

Automatisches Fahren in einer Umgebung erfolgt bezugnehmend auf eine elektronisch nutzbare Repräsentation der Umgebung, die die Umgebung ortsaufgelöst bzw. ortsauflösend darstellt. Eine solche Repräsentation wird im Nachfolgenden auch kurz als "Karte" oder "elektronische Karte" bezeichnet. Zur Situation der Fig. 3 könnte eine solche Umgebungsrepräsentation/Karte/elektronische Karte mindestens den Raumgrundriss speichern, die Regale 34 darin, die Positionen der Tore 37 und Türen 38 und gegebenenfalls auch die Positionen der Navigationshilfen 39.

Mindestens anfänglich nicht enthalten sind dagegen Flächenbelegungen etwa im Freilager 35 oder durch momentan vorhandene Fußgänger oder andere Fahrzeuge. Mit bestimmten Kartenaktualisierungsalgorithmen ist es allerdings möglich, dass auch solche transienten Belegungen Eingang in eine Karte finden, gegebenenfalls statistisch gewichtet.

Die Ortsauflösung der Karte entspricht den Notwendigkeiten und kann im Zentimeter- oder Millimeterbereich liegen. Auch die Umgebung eines Roboterarms kann wie beschrieben kartiert sein.

Wenn eine Simulation vorzunehmen ist, kann ein Anfangszustand oder ein momentaner Zustand in der zu simulierenden Umgebung genommen und in vielen zeitdiskreten Schritten rekursiv/iterierend weitergerechnet werden. Der momentane Zustand kann beschrieben werden einerseits durch die elektronische Karte und andererseits durch Daten, die das Verhalten mobiler Objekte und anderer Objekte in der Umgebung beschreiben. Namentlich können für jedes automatische Fahrzeug 32, für jedes geführte Fahrzeug 33 und für jeden Fußgänger 31 Datentupel aus Position und Ausrichtung, lineare Geschwindigkeit, Winkelgeschwindigkeit, lineare Beschleunigung, Winkelbeschleunigung, Größe und weiteren Daten existieren. Mit ihnen kann eine gegebene Situation (Anfangssituation) in eine nach einem bestimmten Zeitraum vorliegenden Endzustand weitergerechnet werden, wobei ein solcher Zeitraum vergleichsweise kurz sein kann, etwa eine Sekunde oder eine oder mehrere Zehntelsekunden oder noch kürzer. Insoweit kann die Simulation iterativ erfolgen, also dahingehend, dass ein errechneter Endzustand als neuer Anfangszustand genommen und von dort aus weitergerechnet wird, bis ein internes oder externes Abbruchkriterium für die Simulation vorliegt.

Gleichzeitig kann es zu simulierten Eingriffen kommen, etwa indem simulierte Lenkeinschläge geändert werden oder indem simulierte Erfassungen eine Annäherung an ein anderes Objekt anzeigen, das einen Eingriff erforderlich macht. Insoweit erfasst die Simulation also einerseits die normale physikalische Dynamik bewegter Körper, aber andererseits auch Eingriffe, die notwendig sind, um Aufträge auszuführen und um die Sicherheit des automatischen Fahrens zu gewährleisten. Die Simulation umfasst also auch sicherheitsrelevante Aspekte wie Kollisionsverhinderung und somit auch Sensoriksimulation, Aktoriksimulation und ähnliches. Dies alles hängt wiederum von verschiedenen Parametern ab.

Um die Sicherheit automatischen Fahrens zu gewährleisten, werden verschiedene Maßnahmen getroffen. Art und Umfang hängen allerdings vom jeweiligen Einsatzort und auch von den geltenden Bestimmungen ab. Sicherheitsrelevante Parameter sind:
- Hardwareredundanz: Sensorik ist doppelt so überlappend vorhanden, um den Ausfall eines Sensors kompensieren zu können. Ähnliches gilt für Aktorik (Bremsen).
- Sensorart: Sensoren können unterschiedliche Auflösung haben. Entsprechend der Auflösung steigt die Datenmenge, die zu verarbeiten ist. Wenn die Erfassung im dreidimensionalen Raum erfolgt, steigt die Datenmenge quadratisch mit der Auflösung. Entsprechend der Datenmenge steigt auch die benötigte Rechenleistung.
- Setzen von einzuregelnden Höchstgeschwindigkeiten unter die technisch mögliche Geschwindigkeit,
- Setzen von Schutz- und Warnfeldern um das Fahrzeug herum. Wenn darin unerwartet Objekte erkannt werden, folgen bestimmte Maßnahmen.
- Redundanz in der Steuerung und in der Rechenleistung gegen Ausfall
- Redundanz und Bandbreite in den eingerichteten Kommunikationsschnittstellen zu anderen Fahrzeugen und zu zentralen Komponenten.

Da in vielen Fällen die konkreten Auswirkungen einzelner dieser Maßnahmen auf das Sicherheitsverhalten der Gesamtanlage unbekannt sind, wird derzeit häufig die Systemauslegung auf maximale Sicherheit gesetzt. Teilweise ist dies auch mangels anderer tragfähiger Vorgaben von Versicherungen und ähnlichem gefordert. Dies führt dann miteinander zu einerseits teurer Hardware und andererseits wegen der vielen Sicherheitsüberprüfungen und strenger Parameter zu gestörtem und langsamem Ablauf.

Eine Abhilfe hierfür ist die langfristige Beobachtung real vorhandener Verkehrssituationen und daraufhin die angepasste Einrichtung der Ausstattung der automatisch befahrbaren Umgebung. Dies ist aber langwierig und kann viele Monate bis hin zu einem Jahr dauern und ist auch personal- und damit kostenintensiv.

Der Artikel "Robotic Forklifts ... " von Kelen und anderen in ICIT 2010, Seiten 1465 bis 1467, XP031680952, beschreibt die Ortung und Wegplanung von autonom in einem Warenlager fahrenden Gabelstaplern. Die beste Lösung eines RoutingAlgorithmus wird simuliert.

Der Artikel "CARLA: An Open Urban Driving Simulator" von Dosovitskiy und anderen in "Ist Conference on Robot Learning" 2017, Seiten 1 bis 16, XP081287280, beschreibt einen Simulator für die Erforschung autonomen Fahrens. In einer erschaffenen virtuellen städtischen Umgebung kommen verschiedene Ansätze für simuliertes autonomes Fahren zur Anwendung.

Es ist Aufgabe der Erfindung, ein Verfahren und eine Vorrichtung zur Ermittlung eines oder mehrerer Fahrzeugparameter für ein autonom fahrendes Fahrzeug für eine automatisch befahrbare Umgebung anzugeben, die die schnelle und belegbare Ermittlung solcher Fahrzeugparameter ermöglichen.

Diese Aufgabe wird mit den Merkmalen der unabhängigen Patentansprüche gelöst.

Ein Verfahren zur Ermittlung eines oder mehrerer Fahrzeugparameter für ein in einer automatisch befahrbaren Umgebung autonom fahrendes Fahrzeug hat die Merkmale des Anspruchs 1. Es wird zunächst eine elektronische Karte bereitgestellt. Darüber hinaus werden Parameter bereitgestellt, die zu simulierende Eigenschaften von Fahrzeugen und zu simulierende summarische Eigenschaften des zu simulierenden Gesamtverkehrs in der Umgebung beschreiben. Bezugnehmend auf die Karte und die Parameter wird der Verkehr in der Umgebung simuliert. In der Simulation erfolgt das Erfassen von Ereignissen von Interesse und das Zählen derselben. Anhand der Zählergebnisse wird der bzw. werden die gewünschten Parameter ermittelt, die zuletzt gespeichert und/oder ausgegeben werden.

Die ermittelten Parameter können Schutz- und Warnfelddefinitionen sein.

Durch das Definieren und Zählen von Ereignissen von Interesse während der Simulation können bei geeigneter Definition dieser Ereignisse im Hinblick auf die gewünschten Aussagen zur Sicherheit der Umgebung eben solche Eigenschaften erkannt und quantifiziert werden.

Die Simulation kann eine zeitdiskrete schrittweise Simulation der Bewegung der einzelnen Objekte einschließlich automatischer Fahrzeuge, fahrergeführter Fahrzeug und Fußgänger sein. Die Taktung (Schrittweite auf der Zeitachse) kann im Bereich von Sekunden oder Zehntelsekunden liegen. Die "Beschleunigung" des simulierten Verkehrens gegenüber dem realen Verkehr hängt stark von der involvierten Rechnerleistung und von der Größe der zu simulierenden Umgebung bzw. der Anzahl der zu simulierenden Fahrzeuge/Personen ab. Es kann aber angenommen werden, dass beispielsweise eine Beschleunigung der Simulation gegenüber der Realität um den Faktor 100.000 erreichbar ist. Dies bedeutet, dass ein realer Tag (mit 86.400 Sekunden) in weniger als einer Sekunde simuliert werden kann und dass beispielsweise ein ganzes Jahr Verkehr in ca. fünf Minuten simuliert werden kann. Zehn Jahre Verkehr sind dann in unter einer Stunde simulierbar. Es können dann über einen so langen simulierten Zeitraum statistisch signifikante Werte erzeugt werden, namentlich in der Simulation zunächst Zählwerte von Ereignissen von Interesse.

"Automatisches Fahren" im Sinne dieser Beschreibung kann bedeuten, dass ein Fahrzeug ferngesteuert fährt, also seine die Dynamik betreffenden Befehle (bremsen, beschleunigen, lenken, konstant weiter, ...) von einer entfernten Stelle (z. B. zentrale Steuerung) erhält, vorzugsweise drahtlos und nach Maßgabe von Daten, die in Echtzeit die momentan geltende Situation in der befahrenen Umgebung beschreiben. Diese Daten können vom Fahrzeug selbst erfasst und weitergeleitet worden sein und/oder aus anderen Datenquellen stammen. Es kann auch bedeuten, dass ein Fahrzeug autonom fährt, also ein Ziel selbständig ansteuert und seine hierfür nötigen, die Dynamik betreffenden Befehle nach Maßgabe der genannten Daten selbst generiert. Automatisches Fahren kann auch eine Mischform ferngesteuerten und autonomen Fahrens sein. Es kann führerlos oder mit einer überwachenden Person sein.

Es können unterschiedliche Arten von Ereignissen von Interesse definiert sein und die Zählung getrennt für jede der Arten erfolgen. Arten können etwa sein unbehinderter Verkehr, zähfließender Verkehr, Stau, kritische Situation ohne Schaden, Sachschaden, Personenschaden, Schutzfeldverletzung, Warnfeldverletzung, das Entstehen von Quetschstellen, Planerstellung, Planänderung und dergleichen. Quetschstellen sind Stellen, an denen der Abstand zwischen irgendeinem Fahrzeugteil und einem umgebenden Objekt ein gewisses vordefiniertes Mindestmaß unterschreitet (etwa 40 cm oder 30 cm), so dass es wahrscheinlich zu Personenquetschungen käme, wenn dort eine Person wäre. Sie können zusätzlich zu und unabhängig von Schutz- und Warnfeldern überwacht und bei Entstehen als Ereignis von Interesse gezählt werden.

Die obigen Definitionen können zu Doppelzählungen führen (Schutzfeldverletzung auch als Warnfeldverletzung und/oder als Entstehung einer Quetschstelle). Wenn gewünscht kann dies in der Simulation überwacht und durch priorisiertes Zählen eines Ereignisses gegenüber einem auch stattfindenden anderen) ausgeschlossen werden

Unbehinderter, zähfließender Verkehr oder Stau können etwa anhand von Geschwindigkeitsbereichen unterschieden werden. Das Zählen von Ereignissen von Interessen kann dabei ereignisgesteuert sein (etwa bei der Erkennung einer simulierten Kollision als Sachschaden) oder zeitgesteuert (beispielsweise einmal pro Sekunde) oder fahrweggesteuert (beispielsweise einmal pro Meter) oder auch positionsgesteuert.

Die Ereignisse von Interesse werden in der Simulation erfasst, indem geeignete Auswertealgorithmen die jeweiligen Daten der simulierten Bewegungen auswerten. Die Zählwerte werden dann getrennt für die jeweilige Art des interessierenden Ereignisses hochgezählt. Naturgemäß können sie deutlich unterschiedliche Zählerstände erreichen (unbehinderter Verkehr hoch, zähfließender Verkehr, Stau weniger hoch, Auftragserstellung hoch entsprechend Verkehrsaufkommen, Auftragsänderung niedrig, kritische Situation/Fast-Schaden, Fahrzeugschaden, Personenschaden niedrig).

Die Zählwerte können dann zu den gewünschten Fahrzeugparametern weiterverarbeitet werden oder als Abbruchkriterium für eine Simulation dienen und/oder als Bewertung eines oder mehrerer Fahrzeugparameter der Simulation verwendet werden.

Die Simulation erfolgt bezugnehmend mindestens auf Fahrzeugparameter und Verkehrsparameter. Fahrzeugparameter können Ausstattungsparameter eines Fahrzeugs und Dynamikparameter eines Fahrzeugs umfassen. All diese Parameter gehen in die Simulation ein, indem ihre Auswirkungen auf die Fahrzeugbewegung simuliert werden.

Die Ausstattungsparameter eines Fahrzeugs können Sensorikeigenschaften umfassen, gegebenenfalls mit zugehörigen Fehlerwahrscheinlichkeiten, insbesondere Redundanz der Sensorik und Ortsauflösung der Sensorik, Aktorikeigenschaften, gegebenenfalls mit zugehörigen Fehlerwahrscheinlichkeiten, insbesondere Lenkverhalten, Bremsverhalten, Beschleunigungsverhalten, Steuerungseigenschaften, gegebenenfalls mit zugehöriger Fehlerwahrscheinlichkeit, insbesondere Redundanz der Steuerung, Fehlerhäufigkeit, Kommunikationseigenschaften, gegebenenfalls mit zugehörigen Fehlerwahrscheinlichkeiten, insbesondere Redundanz der Gerätschaften, Verbindungsstabilität, Verbindungsqualität, Verbindungsgeschwindigkeit. Beispielsweise kann das Zusammenbrechen der Kommunikation mit anderen Fahrzeugen oder mit einer Zentralsteuerung (simuliert) zu einer (simulierten) Verlangsamung oder Planänderung oder ähnlichem führen, um etwa ein Fail-Save-Verhalten zu simulieren. (Simulierte) Steuerungsfehler können beispielsweise zu ungeeigneten Steuerungseingriffen führen, also etwa Fehllenkung. Aktorikfehler können beispielsweise Bremsfehler sein. Sensorikeigenschaften bzw. Sensorikfehler können Fehldetektion der Umgebung einschließen, gegebenenfalls auch Sensorausfall mit einhergehenden Fail-Save-Strategien und ähnliches. Auch diese Ereignisse können simuliert werden und können zu Ereignissen von Interesse führen, die dann gezählt werden.

Dynamikparameter eines Fahrzeugs können gesetzte Höchstgeschwindigkeitswerte sein, gesetzte Höchstbeschleunigungswerte (positiv wie negativ - Bremsung), Abstandswerte zu beweglichen und unbeweglichen Objekten während der Fahrt, und Schutz- und Warnfelder.

Es sei in diesem Zusammenhang darauf hingewiesen, dass in einer Umgebung unterschiedliche Fahrzeuge automatisch fahren können. Unterschiedliche Fahrzeuge können unterschiedliche Parameter haben, sodass sie sich auch in der Simulation unterschiedlich simuliert verhalten.

Auch fahrergeführte Fahrzeuge und Fußgänger/Radfahrer können durch geeignete Parameter (jeweils z. B. mit bestimmter Häufigkeit, bestimmten typische/untypische Anfangs- und Endpunkten bzw. Trajektorien dazwischen) in die Simulation einbezogen werden.

Die summarischen Verkehrsparameter des zu simulierenden Verkehrs können einen oder mehrere der folgenden Parameter umfassen: Arten und jeweilige Anzahl der automatisch fahrenden Fahrzeuge incl. statistische Schwankungen sowie determinierte Schwankungen (etwa abhängig von der Tageszeit) einschließen, Anzahl von nicht automatisch fahrenden Fahrzeugen (also fahrergeführten Fahrzeugen) und/oder Fußgängern in der Umgebung, auch wieder gegebenenfalls mit statistischen und determinierten (etwa tageszeitabhängigen) Schwankungen, Vorzugsrichtungen und/oder Vorzugspfade und/oder Vorzugsorte der Fahrzeuge und/oder Fußgänger, wieder gegebenenfalls mit statischen und determinierten Schwankungen, Betriebsfehlerwahrscheinlichkeiten (etwa herabfallende Güter), Kartenfehlerwahrscheinlichkeiten, Ausstattung der Umgebung mit aktiven und/oder passiven Navigationshilfen.

Die oben genannten Parameter können in die Simulation einbezogen werden, generieren dann individuellen simulierten Verkehr und führen dann jeweils zu Beeinflussungen des Verhaltens der dynamischen Objekte (Fahrzeuge, Fußgänger). Dies wiederum kann zum Auftreten der genannten Ereignisse von Interesse führen, die dann gezählt und somit quantifiziert werden können.

Wenigstens Teile der genannten summarischen Verkehrsparameter des zu simulierenden Verkehrs werden entsprechend realen Beobachtungen oder realen Zielvorgaben für die reale, kartierte und dann zu simulierende Umgebung gesetzt. Solche realen Parameter können sein Fahrzeugarten und deren jeweilige Parameter, Anzahl der jeweiligen Fahrzeuge, gegebenenfalls auch über der Zeit schwankend wie erwähnt, Vorzugspfade (oft gefahrene Pfade) und/oder oft angefahrene Orte, selten gefahrene Pfade, selten angefahrene Orte. Die Simulation wird so eingerichtet, dass diese real ausgerichteten Parameter getroffen/realisiert sind, so dass das Simulationsergebnis gut mit realen Verhältnissen übereinstimmt.

Die Simulation kann auch derart makroskopisch iterierend sein, dass nach Durchführen eines ersten Simulationsteils simulationsrelevante Eingangsgrößen (Parameter) geändert werden und auf der Grundlage der geänderten Größen ein weiterer Simulationsteil vorgenommen wird. Die Zählung von Ereignissen von Interesse erfolgt dann jeweils getrennt für die Simulationsteile. Die zu den jeweiligen Simulationsteilen gehörigen Zählwerte werden gespeichert. Auch die den jeweiligen Simulationen zugrunde liegenden Parameter werden zuordenbar gespeichert.

Ein typisches Szenario kann etwa folgendes sein: Mit einem ersten Parametersatz wird eine Simulation über etwa ein simuliertes Jahr gefahren. Diese zeigt einen vergleichsweise hohen Zählwert für kritische Situationen. Es werden dann sicherheitsrelevante Parameter geändert, etwa Höchstgeschwindigkeiten, Abstände, Schutzfelder, Warnfelder und ähnliches. Auf der Grundlage des geänderten Parametersatzes wird erneut eine Simulation gefahren. Die Veränderung der Parametersätze kann automatisch nach vorgegebenen Strategien erfolgen oder über eine sonstige Eingabevorrichtung, die z. B. manuellen Benutzereingriff ermöglicht. Insoweit kann eine Eingabeeinrichtung vorgesehen sein zur Entgegennahme geänderter Parameter oder zum Veranlassen des Änderns gegebener Parameter.

Andererseits kann sich während des Laufens eines Simulationsteils ergeben, dass keine relevanten Ereignisse von Interesse wie etwa kritische Situationen, Sachschaden oder Personenschaden auftreten. Wenn nach hinreichend langer Simulationsdauer einer Teilsimulation zu interessierenden Ereignissen keine statistisch signifikanten Zählwerte entstehen, kann dies als Abbruchkriterium für diesen Simulationsteil genommen werden. Es kann dann ein weiterer Simulationsteil mit geänderten Parametern angestoßen werden, etwa mit höheren zulässigen Maximalgeschwindigkeiten, geringeren Abständen, kleineren Schutz- und/oder Warnfeldern oder ähnlichem. Es kann dann abermals geprüft werden, ob Zählwerte mit statistischer Signifikanz entstehen, und wenn ja, können die Zählwerte als Bewertung des jeweiligen Parametersatzes verwendet werden.

Das wiederholte Fahren von Simulationen mit geänderten Parametern kann mehrfach vorgenommen werden, und es können auf diese Weise mehrere Sätze von Zählwerten entstehen. Es können also für jeden Simulationsteil eigene Zählwerte und Fahrzeugparameter ermittelt werden und die einer geeigneten Simulation zugrunde liegenden Parameter als geeignet gewählt werden.

Insbesondere können dann Fahrzeugparameter, die zur Simulation der Bewegung eines Fahrzeugs während der Simulation verwendet wurden, tatsächlich zur Ausstattung und/oder Steuerung der realen Fahrzeuge in der realen Umgebung verwendet werden. Dies kann für solche Fahrzeugparameter erfolgen, für die sich die ergebenden Zählwerte als geeignet erweisen. Die dafür maßgeblichen Simulationsparameter können dann als die Fahrzeugparameter für die automatisch mit Fahrzeugen befahrbare Umgebung genommen werden.

Eine weitere Möglichkeit der Änderung von der Simulation zugrunde liegenden Parametern ist es, die elektronische Karte zu ändern. Im realen Abbild würde dies einer Umgestaltung der abgebildeten Umgebung entsprechen bzw. ist als Vorschlag dafür zu verstehen. Auch solche Abänderungen nach Ende eines Simulationsteils und vor Beginn eines weiteren Simulationsteils können auf eine geeignete Eingabe von einer Eingabeeinrichtung her erfolgen. Vorzugsweise geschieht dies in einer Kopie der elektronischen Karte, da ja nicht gesagt ist, dass die Umgebungsveränderung, die der Kartenänderung entsprechen würde, sinnvoll ist. Bezugnehmend auf die geänderte Karte wird dann abermals ein Simulationsteil gefahren. Änderungen der elektronischen Karte können etwa bedeuten, dass (in Fig. 3 beispielhaft) Regalabstände vergrößert werden (in Fig. 3 beispielsweise zwischen 34a und 34b und/oder zwischen 34b und 34c), oder dass Regale verkleinert werden (etwa Links-Rechts-Ausdehnung der Regale 34a und 34b in Fig. 3) und ähnliches. Auch die zulässige Fläche für das Freilager 35 kann geändert werden. Wenn eine auf der Grundlage der so geänderten elektronischen Karte gefahrene Simulation zufriedenstellende Zählwerte ergibt, kann die so überprüfte Kartenänderung als Kennwert für die automatisch mit Fahrzeugen befahrbare Umgebung genommen und als Vorschlag zur Änderung der realen Topologie verstanden werden.

Allgemein kann die Betrachtung der Zählwerte dahingehend erfolgen, ob sie unter oder über einem gegebenen Schwellenwert liegen und gegebenenfalls auch, ob sie statistisch signifikant sind. Wenn mehrere Zählwerte zu unterschiedlichen Arten von Ereignissen von Interesse erhoben werden, können sie selektiv und/oder gewichtet betrachtet bzw. verrechnet werden. Es können insbesondere Zählwerte zu kritischen Situationen und/oder Schadensfälle (Personenschaden, Sachschaden) als alleinige Beurteilungskriterien und/oder hoch gewichtet herangezogen werden. Wie schon ausgeführt kann darüber hinaus bei diesen Überprüfungen statt der Betrachtung der reinen Zählwerte auch die Betrachtung abgeleiteter Werte erfolgen, etwa bezogener/relativer Werte, etwa bezogen auf einen Standardzeitraum (beispielsweise Jahr) oder bezogen auf ein Fahrzeug oder bezogen auf einen Ort oder ähnliches.

Soweit etwa "normaler" oder "zähfließender Verkehr" oder "Stau" als Ereignisse von Interesse gezählt werden, kann dies in einen relativen Zeitanteilswert umgerechnet werden (etwa 5 Zeit-% Stau, 17 Zeit-% zähfließend, Rest normal). Statt auf Zeit kann auch auf gefahrene Strecke als Bezugsgröße abgestellt werden. Ereignisse wie Stau, Zähfluss und Normalfluss des Verkehrs können anhand von Geschwindigkeitsschwellenwerten unterschieden werden, die überprüft werden, wenn keine sonstigen geschwindigkeitsbeschränkenden Ereignisse (etwa Ladetätigkeit) vorliegen.

Die Kennwerte für eine automatisch mit Fahrzeugen befahrbare Umgebung werden also bezugnehmend auf das Zählergebnis für die Ereignisse von Interesse während der Simulation (gegebenenfalls mehrere Arten von Ereignissen von Interesse mit jeweiligen Zählwerten) ermittelt. Im einen Fall können es zur abstrakten Bewertung einer Umgebung zusammen mit zugehörigen Parametersätzen die Zählwerte selbst sein oder daraus abgeleitete Werte wie die schon genannten bezogenen Größen. In einem weiteren Fall können die Kennwerte Parameter sein, auf deren Grundlage eine Simulation mit zufriedenstellenden Zählwerten gefahren wurde, wobei die Parameter dann für die tatsächliche Fahrzeugsteuerung verwendet werden können. In noch einem weiteren Fall können die Kennwerte Kartenänderungen sein, die als Vorschläge zur Änderung in der Umgebungstopologie verstanden werden können.

Simulationsergebnisse werden gespeichert. Die zueinander gehörigen Daten, insbesondere Simulationsparameter und Zählwerte werden einander zuordenbar gespeichert. Auch die einzelnen Simulationsschritte selbst können für eine spätere oder parallele anderweitige Auswertung gespeichert werden. Die Speicherung erfolgt so, dass zueinander gehörige Daten (insbesondere Daten eines Simulationsteils) einander zuordenbar gespeichert werden.

Rechnertechnisch betrachtet kann die Simulation selbst (Simulation der Bewegung der beweglichen Objekte) von einem Rechner oder von mehreren vernetzten Rechnern durchgeführt werden. Das Erfassen und Zählen von Ereignissen von Interesse kann von den gleichen (simulierenden) Rechnern oder von anderen Rechnern vorgenommen werden, die dann auf von den simulierenden Rechnern erzeugte Ausgaben oder gespeicherte Werte zugreifen.

Eine Simulation bzw. ein Simulationsteil kann abgebrochen werden, wenn entweder bestimmte Zählwerte (insbesondere kritische Zählwerte - kritische Situationen oder Schadensfälle) absolut oder relativ betrachtet bestimmte Grenzen überschreiten oder unterschreiten. Sie kann auch dann abgebrochen werden, wenn nach einer bestimmten simulierten Zeitdauer für die interessierenden Zählwerte keine Zahlen statistischer Signifikanz entstehen.

Das wiederholte Vornehmen einzelner Simulationen (also Durchführen mehrerer Simulationsteile) kann abgebrochen werden, wenn eine vorgegebene Simulationenfolge abgearbeitet ist oder wenn in einem Simulationsteil befriedigende Parameter/Kennwerte gefunden wurden.

Innerhalb eines Simulationsteils können Ereignisse von Interesse für lediglich ein einzelnes Fahrzeug erfasst und gezählt werden. Sie können aber auch für mehrere Fahrzeuge für jedes Fahrzeug einzeln oder über diese Fahrzeuggruppe hinweg kumuliert gezählt werden. Sie können auch für alle Fahrzeuge einzeln oder für alle simulierten Fahrzeuge kumuliert gezählt werden.

Das Zählen von Ereignissen von Interesse und/oder die Kennwertermittlung kann auch ortsauflösend erfolgen. Dies kann eine Zählung sein, die parallel zu anderen Zählungen (etwa fahrzeugbezogen oder kumuliert) vorgenommen wird. Beispielsweise kann über die elektronische Karte ein (virtuelles) Gitter einer geeigneten Größe (beispielsweise quadratisch mit 0,5 m Gitterkonstante) gelegt werden und dann für jede so entstehende Kachel interessierende Ereignisse (etwa Sachschaden, Personenschaden, Stau, Zähfluss) gezählt werden. Auf diese Weise entstehen ortsaufgelöste Informationen zur Qualität und Sicherheit des Verkehrsflusses in den jeweils betrachteten Kacheln der Umgebung. Auch die Gesamtheit der so entstehenden ortsaufgelösten Informationen (gegebenenfalls wieder als absolute Zählwerte oder relativ/bezogen wie oben beschrieben) kann als Kennwerte für die automatisch mit Fahrzeugen befahrbare Umgebung verstanden werden.

Das Simulieren des Verkehrs kann umfassen, dass in a priori befahrbaren Bereichen (36 in Fig. 3) temporäre Hindernisse/statische Objekte entstehen, etwa sich stauende Fahrzeuge oder liegen gebliebene/defekte Fahrzeuge oder planvoll abgelegte Objekte (etwa im Freilager 35 oder aus dem Regal herausragende Objekte). Die Simulation kann insoweit umfassen, dass sie weitere simulierte Objekte generiert, die in die Simulation einbezogen werden. Solche generierten Objekte können mit ihrer Größe und ihrer Position und Ausrichtung zusammen mit Geschwindigkeit 0 in die Simulation einbezogen werden. Wenn andererseits ein abgelegtes Objekt wieder entfernt wurde, kann das zugehörige simulierte Objekt aus der Simulation herausgenommen werden.

Die Erfindung kann zur schnellen Definition der Flottenparameter der Fahrzeugflotte einer automatisch zu befahrenden Umgebung beitragen. Regelmäßig tritt die Situation auf, dass bspw. eine Lagerhalle mit einem neuen Transportsystem oder Teilen davon, bspw. neuen Transportfahrzeugen auszustatten ist, gerade dann, wenn von konventionellem Betrieb mit fahrergeführten Fahrzeugen auf automatischen Betrieb vorzugsweise mit führerlosen Fahrzeugen umgestellt wird. Es können dann Fahrzeugparameter in einem Simulationsteil gesetzt und simuliert und in folgenden Simulationsteilen variiert werden. Auch real beobachtete Parameter zum real herrschenden Verkehr können ermittelt und in einem Simulationsteil genützt werden.

Die Auswirkung der Varianten auf die Zählwerte zu den Ereignissen von Interesse ist ein Maß für die Qualität des (geänderten) Parameters. Es können auf diese Weise Parameter variiert und in ihrer Auswirkung auf das Gesamtsystem bewertet werden. Geeignete Parameter können dann die Grundlage einer realen Implementierung werden.

Eine Vorrichtung zur Ermittlung eines oder mehrerer Fahrzeugparameter für eine automatisch mit Fahrzeugen befahrbare Umgebung ist zur Durchführung des beschriebenen Verfahrens ausgelegt.

Allgemein betrifft die Erfindung eine Vorrichtung, die zur Durchführung der angegebenen Verfahren ausgelegt ist und einen Rechner oder ein Rechnernetz und geeignete Verbindungs-, Eingabe-, Ausgabe- und Speichereinrichtungen aufweist.

Die oben beschriebenen Merkmale sollen auch auf und für die Bewegung eines Roboters oder Roboterarms als Fahrzeug in seiner Umgebung anwendbar verstanden werden.

Nachfolgend werden bezugnehmend auf die Zeichnungen Ausführungsformen der Erfindung beschrieben, es zeigen:
- Fig. 1: allgemein ein Verfahren zur Fahrzeugparameterermittlung für eine automatisch befahrbare Umgebung,
- Fig. 2: eine Option des Verfahrens der Fig. 1,
- Fig. 3: beispielhaft eine Umgebung, für die und in der das Verfahren angewendet werden kann,
- Fig. 4: beispielhaft schematisch ein automatisch navigierendes Fahrzeug,
- Fig. 5: ein Fahrzeug in Draufsicht mit Schutz- und Warnfeldern,
- Fig. 6: das Erfassen und Zählen von Ereignissen von Interesse, und
- Fig. 7: eine Simulationsvorrichtung.

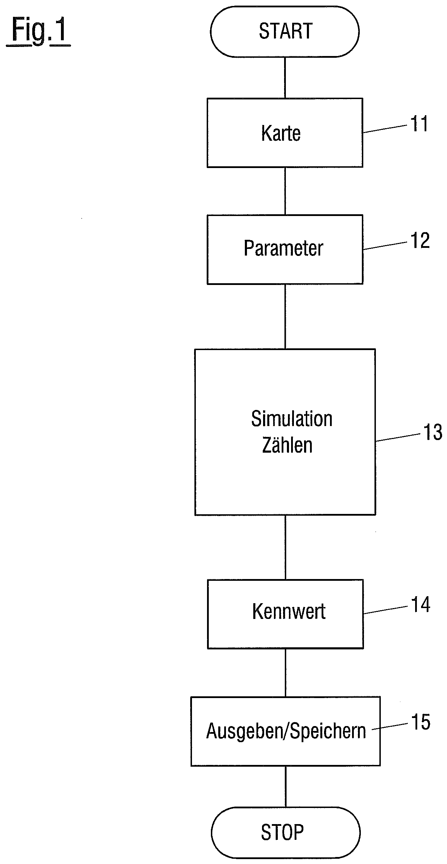

Fig. 1 zeigt schematisch das Verfahren zur Ermittlung eines oder mehrerer Fahrzeugparameter für eine automatisch mit Fahrzeugen befahrbare Umgebung. Im Schritt 11 wird von den simulierenden Komponenten (Rechner, Rechnernetz) eine elektronisch nutzbare Umgebungsrepräsentation aufgerufen bzw. der Zugriff darauf hergestellt. Dies kann beinhalten, dass eine Kopie der zugehörigen Daten genommen wird.

Im Schritt 12 werden Parameter bereitgestellt, auf deren Grundlage die durchzuführende Simulation vorgenommen werden soll. Die Parameter können Fahrzeugparameter und Verkehrsparameter umfassen. Beide können an realen Parametern bzw. real beobachteten Größen angelehnt sein bzw. diese wiederspiegeln. Das Bereitstellen kann durch Neuerstellung/Eingabe und/oder Abruf und ggf. Abänderung gespeicherter Größen erfolgen.

Allgemein kann die Simulation die simulierte Benutzung der kartierten Umgebung umfassen. Typische Nutzungen können simuliert werden, indem sie vorzugsweise zeitdiskret rekursiv rechnerisch längs der Zeitachse durchgerechnet werden. Das Durchrechnen kann die Annahme eines Anfangszustands, das Fortrechnen desselben in einen Endzustand nach einem bestimmten Zeitschritt nach Maßgabe relevanter Parameter, das Auswerten des Endzustands, das Annehmen des Endzustands als neuen Anfangszustand und dann Wiederholung der Fortrechnung erfolgen. Der Zeitschritt kann kurz sein, z. B. unter 1 Sekunde, z. B. 0,2 Sekunden. Eine Stunde Nettobetrieb würde dann mit 3.600 * 5 = 18.000 Iterationen simuliert werden.

Die Simulation umfasst das Belegen der virtuellen kartierten Umgebung mit virtuellem Verkehr, der wie eben beschrieben rekursiv durchgerechnet werden kann. Der virtuelle Verkehr kann eine Anzahl (viele) virtueller Fahrten einer Anzahl (vieler) virtueller Fahrzeuge (incl. Fußgänger, Fahrrad, ...) umfassen, wobei eine Fahrt als Bewegung zwischen Anfangs- und Endpunkt ggf. über einen oder mehrere Wegpunkte ggf. einschließlich Haltepunkten und Haltezeiten in der virtuellen Umgebung definiert sein kann. Der konkrete Weg (Trajektorie) der Fahrt kann auch in der Simulation längs eines vorgegebenen Pfads erfolgen oder ad hoc durch einen geeigneten (vorzugsweise einen real verwendeten) mitsimulierten Navigationsalgorithmus entschieden werden.

Das Belegen der virtuellen kartierten Umgebung mit virtuellem Verkehr erfolgt qualitativ und quantitativ möglichst realitätsnah. Die den realen Verkehr charakterisierenden summarischen Real-Parameter werden in der Simulation möglichst realitätsnah nachgebildet. Dies umfasst zunächst, dass die den realen Verkehr charakterisierenden summarischen Real-Parameter definiert, ermittelt und als elektronisch nützbare Datensammlung bereitgestellt werden. Sie können statistische und absolute Parameter umfassen, etwa einen oder mehrere der folgenden Parameter:
- Typen und Anzahl der Fahrzeuge,
- Anzahl der Fahrten (pro Zeit und ggf. pro Fahrzeug),
- typische Sätze von Anfangs-, End- und Haltepunkten von Fahrten und ggf. Trajektorien hierzu,
- Anzahl von Personen und deren Bewegungen in der Umgebung,
- Anzahl von personengeführten Fahrzeugen und deren Bewegungen in der Umgebung,
- typische Sätze von Anfangs-, End- und Haltepunkten von Fahrten und ggf. Trajektorien hierzu,
- Fehlerwahrscheinlichkeiten in Fahrzeugen,
- Routingverfahren (z. B. ferngesteuert, autonom), Routingalgorithmus,

Die Parametern, die summarische Eigenschaften des zu simulierenden Verkehrs in der Umgebung beschreiben, können qualitativ (ihrer Art nach) und ggf. auch quantitativ den Real-Parametern entsprechen oder können ihnen gegenüber qualitativ und/oder quantitativ verändert sein.

Die den zu simulierenden Verkehr charakterisierenden summarischen Parameter können auf verschiedene Weisen mit realitätsnahen Werten belegt werden, etwa
- Beobachten und entsprechendes Auswerten und Quantifizieren des realen Verkehrs in der realen Umgebung (falls vorhanden), und Übernahme dieser realen Parameter als die summarischen Parameter des zu simulierenden Verkehrs,
- Beobachten und entsprechendes Auswerten und Quantifizieren des realen Verkehrs in einer anderen, vorzugsweise gleichen oder ähnlichen (ähnlich großen, ähnlich belegten) realen Umgebung und ggf. Anpassen und Skalieren dieser realen Parameter zum Erzeugen der summarischen Parameter des zu simulierenden Verkehrs,
- Kombination der obigen Maßnahmen.

Wenn die die Realität beschreibenden Real-Parameter definiert, ermittelt und elektronisch nützbar aufbereitet, etwa in einer Datenbank gespeichert sind, dienen sie als Grundlage für die Ermittlung der Parametern, die summarische Eigenschaften des zu simulierenden Verkehrs in der Umgebung beschreiben, und diese dienen wiederum der Erzeugung des konkreten simulierten Verkehrs während der konkreten Simulation, indem Nutzungen, insbesondere Fahrten (auch fahrergeführte) und Fußgänger so simuliert werden, dass langfristig der simulierte Verkehr die gleichen oder hinreichend ähnliche Parameter zeigt wie diejenigen, die real ermittelt wurden.

Die Angleichung des simulierten Verkehrs an den realen Verkehr kann bspw. dadurch geschehen, dass Fahraufträge in passender Anzahl, aber mit gesteuerten Wahrscheinlichkeiten z. B. für Anfangs-, End- und Haltepunkte incl. Haltezeiten erzeugt und dann simuliert durchgeführt/durchgerechnet werden. Beispielsweise kann ein kleiner Satz von Fahraufträgen erzeugt werden, der den statistischen Parametern entspricht und der dann vielfach verwendet wird, bis die gewünschte Gesamtzahl erreicht ist. In den Wiederholungen können Veränderungen der Aufträge vorgenommen werden, die um die gesetzten Werte herum zufallsgesteuert oder quasizufallsgesteuert sind. Auch die Anfangszeitpunkte von Fahrten gemäß Fahraufträgen können variiert werden.

Im Schritt 13 erfolgt die Simulation der Nutzung/Befahrung der automatisch befahrbaren Umgebung. Dies kann das "Besiedeln" der Umgebung mit dem gewünschten simulierten Verkehr und die genannte Iteration/Rekursion mit vielen Schleifen enthalten. Die Simulation umfasst das Einstellen einzelner virtueller Fahrten und Bewegungen, die wie oben definiert werden können, in die virtuelle Situation und die Simulation der Bewegung der automatisch navigierenden Fahrzeuge, wie auch die Simulation der Bewegung anderer dynamischer Objekte, etwa Fußgänger, Radfahrer und fahrergeführter Fahrzeuge. Die Fahrten und Bewegungen können nach Maßgabe der Abweichung der Parameter des simulierten Verkehrs von den Real-Parametern erzeugt werden, um erstere auf letztere hinzuführen.

Bei der eigentlichen Simulation werden die dynamischen Objekte nicht jeweils einzeln für sich nur in Bezug auf die kartierte Umgebung simuliert, sondern auch in Bezug untereinander, um Effekte wie Stau, Vorfahrt, Fehler etc. simulieren zu können. Die Simulation kann auch die Berücksichtigung temporärer statischer Objekte umfassen, etwa ein liegengebliebenes Fahrzeug oder abgestelltes Objekt.

Ziel der Simulation kann es auch sein, Parameter zu simulieren, die gegenüber der Realität abgewandelt sind. Dies kann Parameter der Fahrzeuge und/oder Verkehrsparameter betreffen. Es kann hier ein Abwandlungsalgorithmus vorgesehen sein, der nach vorgegebenen Kriterien Fahrzeugparameter und/oder Parameter zu summarischen Eigenschaften des virtuellen Verkehrs abwandelt, die dann dem folgenden Simulationsteil zu Grunde gelegt werden. So können bspw. die Verkehrsdichte (Fahrten/Bewegungen pro Zeit) oder die Höchstgeschwindigkeit von Fahrzeugen abgewandelt und diese abgewandelten summarischen Eigenschaften des virtuellen Verkehrs der weiteren Simulation zu Grunde gelegt werden.

Gleichzeitig mit der Simulation oder danach werden Ereignisse von Interesse erfasst und gezählt. Es können mehrere Arten von Ereignissen von Interesse definiert sein und separat gezählt werden. Die Simulation umfasst auch das Überprüfen von Abbruchkriterien einer Simulation (eines Simulationsteils) bzw. einer Folge von Simulationsteilen. Abbruchkriterien können Zählwerte sein und/oder Zeitwerte (simulierte Zeit).

Im Schritt 14 erfolgt das Ermitteln der hier als "Kennwerte" angesprochenen Fahrzeugparameter durch Bezugnahme auf die Zählergebnisse bei der Zählung der Ereignisse von Interesse. Hierbei können für das Ermitteln des Kennwerts oder der Kennwerte die Zählwerte direkt (ggf. selektiv) bzw. relativ bezogen auf eine Bezugsgröße verwendet werden, oder es können Simulationsparameter oder daraus abgeleitete Werte als Kennwerte verwendet werden, und die Zählwerte dienen als Abbruchkriterium für eine Simulation/ein Simulationsteil bzw. als Bewertung der jeweiligen als Kennwerte verwendeten Parameter.

Insbesondere können im Schritt 14 Parameter, die im Schritt 12 bereitgestellt wurden, als die gewünschten Kennwerte genommen werden, oder es können ausgehend von den im Schritt 12 bereitgestellten Parametern andere Parameter als die gewünschten Kennwerte ermittelt werden.

Wenn mehrere Simulationsteile gefahren werden, können zu jedem Teil getrennt Zählwerte erzeugt und ggf. auch Bezug nehmend darauf Kennwerte ermittelt werden. Es entstehen dann mehrere Sätze von Zählwerten und ggf. Kennwerten, aus denen z. B. zuletzt ein passender, etwa nach Maßgabe der Zählwerte, herausgesucht werden kann.

Im Schritt 15 erfolgt das Ausgeben und/oder Speichern der Fahrzeugparameter bzw. Kennwerte. Die Ausgabe kann eine Ausgabe an eine Speichereinrichtung oder an ein Anzeigegerät sein oder auch das Versenden bestimmter Daten über ein Netzwerk.

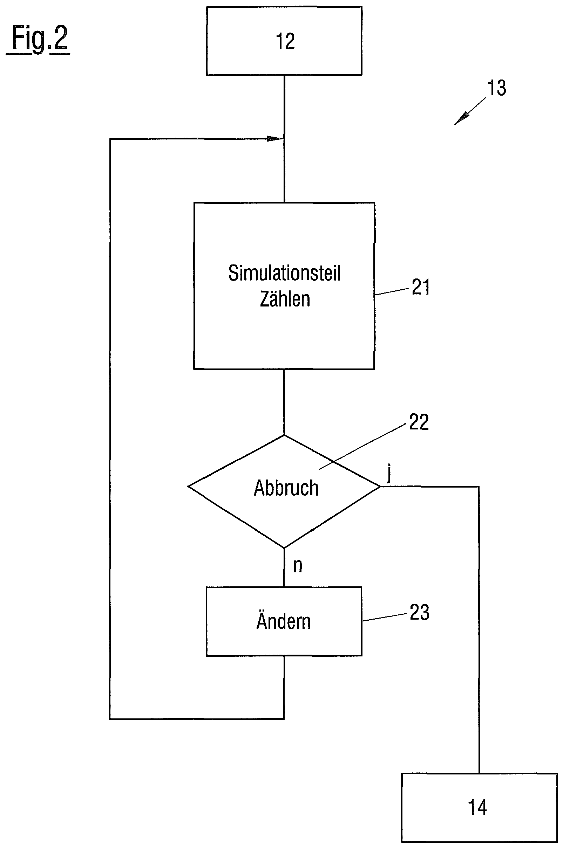

Fig. 2 zeigt eine Ausführungsform der Fig. 1. Sie zeigt insbesondere eine Ausgestaltung der vorzunehmenden Simulation im Schritt 13 der Fig. 1. Nach dem Bereitstellen der Karte und der Parameter im Schritt 12 wird ein erster rekursiver/iterativer Simulationsteil 21 vorgenommen, der in sich eine vollständige Simulation ist. Bei Eintreten eines (nicht gezeigten) Abbruchkriteriums wird die Simulation beendet. Es erfolgt dann auch das Beenden der Erkennung und des Zählens der Ereignisse von Interesse.

Es wird dann im Schritt 22 geprüft, ob ein weiterer Simulationsteil vorgenommen werden soll oder nicht. Dies kann als Abbruchkriterium für die Gesamtsimulation (bestehend aus mehreren Teilsimulationen) verstanden werden. Wenn hier auf "Ja" entschieden wird, wird mit der Kennwertbestimmung im Schritt 14 fortgefahren. Wenn dagegen auf "Nein" entschieden wird, können im Schritt 23 Parameter geändert werden (insbesondere solche, die vorher im Schritt 12 eingeholt wurden), und/oder es können Kartendaten geändert werden (insbesondere solche, die vorher im Schritt 11 eingeholt wurden). Bezugnehmend auf so geänderte Parameter und/oder Kartendaten kann ein weiterer Simulationsteil 21 durchgeführt werden, für die Ereignisse von Interesse separat erfasst und gezählt werden. Wenn hier abermals ein (nicht gezeigtes) Abbruchkriterium erreicht ist, werden wiederum Zählwerte und gegebenenfalls andere Daten diesem Simulationsteil zuordenbar gespeichert, und es wird im Schritt 22 abermals überprüft, ob ein weiterer Simulationsteil durchzuführen ist.

Die Abbruchentscheidung im Schritt 22 kann Bezug nehmend auf die Zählwerte im vorgängigen Simulationsteil 21 erfolgen oder kann anhand vorbestimmter Kriterien getroffen werden. Sie kann auch nach Maßgabe von Daten auf einer Eingabeeinrichtung getroffen werden.

Fig. 3 zeigt die schon eingangs beschriebene zu simulierende Topologie. Mindestens ihre festen Bestandteile sind durch eine elektronisch nutzbare Repräsentation dargestellt. In Fig. 3 ist mit 30 ein stationärer Rechner gezeigt, der im Sinne eines Servers vorgesehen sein kann und der mit notwendigen Systemkomponenten (andere Rechner, Fahrzeuge, stationäre Sensoren etc.) geeignet verbunden ist, entweder leitungsgebunden oder mit den Fahrzeugen 32 drahtlos (WLAN/WIFI, NFC, DECT, Bluetooth o. ä.). Die Systemarchitektur kann insoweit eine Server-Client-Struktur sein oder eine Peer-to-Peer-Struktur oder eine Mischform. Die Struktur des real vorhandenen Systems inklusive seiner realen Konsequenzen (Kommunikation und deren Ausfall bzw. Verzögerung, Komponentenfehler u. ä.) werden in den Schritten 13 bzw. 21 mit simuliert.

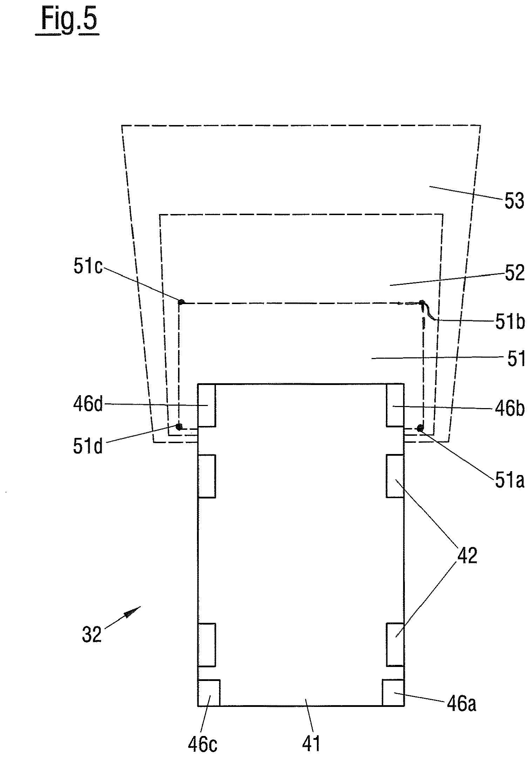

Fig. 5 zeigt schematisch ein automatisch navigierendes Fahrzeug 32 in Draufsicht. 42 sind dessen Räder, 41 ist der Fahrzeugkörper. Es ist angenommen, dass (jedenfalls momentan) in Fig. 5 oben in Fahrtrichtung vorne liegt. Für die Umgebung eines Fahrzeugs können relativ zum Fahrzeug ein oder mehrere Schutzfelder 51 oder Warnfelder 52, 53 definiert sein, die überwacht werden (vorzugsweise innerhalb des Fahrzeugs). Insbesondere wird überwacht, ob planvoll oder ungeplant Objekte in einem der Schutz- oder Warnfelder erkannt werden. Abhängig vom Erfassungsergebnis können unterschiedliche Maßnahmen getroffen werden.

Mit 46 sind Sensoren bezeichnet, mittels derer die Umgebung winkel- und entfernungsauflösend zweidimensional (üblicherweise in einer Ebene) oder dreidimensional (Sphäre bzw. Halbsphäre) abgetastet und auf das Vorhandensein von Objekten überprüft werden kann. Es kann sich hier um die schon genannten LIDAR-, LADAR- oder RADAR-Sensoren handeln. Es können aber auch stereoskopische bildverarbeitende Sensoren sein oder ähnliches. Denkbar ist schließlich auch, dass die Umgebungsdetektion einschließlich der relativ zu einem Fahrzeug definierten Schutz- und Warnfelder 51, 52, 53 von außen (stationären Sensoren 39) überwacht werden. Die gezeigten Sensoren können redundant sein oder können sich ergänzen, etwa unterschiedliche Raumbereiche (mit geringer Überlappung) abdecken.

Fig. 5 zeigt ein Beispiel, bei dem relativ zum Fahrzeug 32 drei ineinander geschachtelte Schutzzonen 51, 52, 53 definiert sind. Die innere Zone 51 ist ein Schutzfeld, 52 und 53 sind Warnfelder. Es handelt sich hierbei um die datentechnische Definitionen virtueller Bereiche, die bei der Überprüfung herangezogen werden. Die Zonen greifen in Fahrtrichtung betrachtet nach vorne unterschiedlich weit aus. Im gezeigten Beispiel sind sie als in etwa rechtwinklig definiert dargestellt. Sie können dann beispielsweise durch Eckpunkte 51a, 51b, 51c und 51d des Schutzfelds 51 definiert sein, wobei die so definierten Kanten das Schutzfeld definieren. Ähnliches gilt für die weiter ausgreifenden Warnfelder 52 und 53.

Wenn in einem Warnfeld Objekte erkannt werden, kann dies zu Maßnahmen wie Absetzen einer Meldung, Ausgeben eines für Menschen wahrnehmbaren Alarms, Geschwindigkeitsverringerung führen. Wenn ein Objekt in einem Schutzfeld erkannt wird, kann dies zum vollständigen Stop, mit starker Abbremsung und weiteren Maßnahmen wie Absetzen einer Meldung und Ausgeben eines für Menschen wahrnehmbaren Alarms führen.

Die in den beschriebenen Simulationen zu simulierenden Fahrzeuge weisen Schutzfeld- und Warnfelddefinitionen wie reale Fahrzeuge auf. Sie werden mitsamt ihrer Überprüfung und Auswertung und der gezogenen Konsequenzen mit simuliert. Abhängig vom Detektionsergebnis der Sensoren 46 zusammen mit der nachläufigen Auswertung können Ergebnisse dahingehend vorliegen, dass in keinem der Schutz/Warnfelder ein Objekt erkannt wurde oder dass in einem der Warnfelder (etwa 53), oder in mehreren (52, also auch in 53) ein Objekt erkannt wurde. Dies muss nicht fehlerhaft sein. Bei der Annäherung an ein Regal kann es planvoll vorkommen, dass das Fahrzeug 32 das kleinere Warnfeld 52 auf den Regalort schiebt. Insoweit umfasst die Überprüfung der Warnfelder 52, 53, ob die Präsenzdetektion eines Objekts planvoll ist oder nicht. Die Simulation beinhaltet auch dieses. Auch das Entstehen von Quetschstellen wie weiter oben beschrieben kann in der Simulation überwacht und gezählt werden.

Abhängig davon, ob und wenn ja wo die Präsenz eines Objekts erkannt wurde, werden Konsequenzen gezogen. Bei planvoller Präsenz (z. B. Annäherung an ein Regal) kann der Plan beispielsweise fortgeführt werden. Bei nicht geplanter Präsenz können unterschiedliche Maßnahmen getroffen werden, etwa Alarm bei Präsenz nur im äußersten Warnfeld 53, Alarm und Verlangsamung bei Präsenz im mittleren Warnfeld 52 und vollständiges Abbremsen bei nicht geplanter Präsenz im inneren Schutzfeld 51. Auch solche Konsequenzen werden simuliert.

Die Definition der Schutz- und Warnfelder (etwa anhand ihrer Ecken 51a bis 51d) kann ein Teil der Parameter sein, die im Schritt 12 der Figur für die vorzunehmende Simulation bereitgestellt werden. Das Festlegen von Schutzfelddefinitionen (etwa Koordinaten der Ecken 51a bis 51d) kann Gegenstand der Parameteränderung im Schritt 23 der Fig. 2 sein.

Schutz- und Warnfelddefinitionen, die in einer Simulation bzw. in einem Simulationsteil verwendet wurden, können Gegenstand der Kennwertermittlung im Schritt 14 sein. Insbesondere können Schutz- und Warnfelddefinitionen (etwa Eckkoordinatenangaben wie in Fig. 5 gezeigt) dann als reale Parameter in realen Fahrzeugen verwendet werden.

Geplante und/oder ungeplante Verletzungen von Schutz- und Warnfeldern 51 - 53 können als Ereignisse von Interesse definiert sein und gezählt werden, ggf. getrennt für unterschiedliche Schutz/Warnfelder.

Es wird hier darauf verwiesen, dass, wie schon gesagt, in einer Umgebung unterschiedliche Fahrzeuge automatisch fahren können, die dann auch unterschiedliche Schutz- und Warnfelddefinitionen haben können. Es werden insoweit dann auch gegebenenfalls unterschiedliche Parametersätze als die gewünschten Kennwerte erzeugt, gespeichert und ausgegeben.

Das Definieren von Schutz- und Warnfeldern für automatisch navigierende Fahrzeuge wird bisher manuell ausgeführt und ist eine aufwändige und zeitraubende Aufgabe, die bisher auf Erfahrungswerten basierend durchgeführt wird. Demgegenüber kann mit dem beschriebenen Verfahren ein Parametersatz, der nach einer Simulation oder einem Simulationsteil als geeignet erkannt wurde, für reale Fahrzeuge verwendet werden, sodass die Generierung von Schutz- und Warnfelddefinitionen markant beschleunigt ist. Die Systemauslegung kann so sein, dass Schutz- und Warnfelddefinitionen, die in der Simulation als geeignet erkannt wurden, in eine geeignete Datenformatierung gebracht werden (soweit sie nicht schon in dieser Formatierung vorliegen), um in realen Fahrzeugen verwendbar zu sein, und kann weiter umfassen, dass die so formatierten Daten an geeignete Empfänger, etwa an einen bestimmten Server und/oder die realen Fahrzeuge zu denjenigen, die simuliert wurden, übertragen und dort dann verwendet werden.

Statt der Schutz- und Warnfelddefinition oder zusätzlich dazu können andere Ausstattungsparameter des Fahrzeugs als die gewünschten Kennwerte bzw. Fahrzeugparameter ermittelt (und ggf. vorher als Simulationsparameter gesetzt) werden, etwa Steuerungsparameter wie Höchstgeschwindigkeiten und Beschleunigungen, Hardwareparameter wie Sensorqualität (Auflösung), Sensoranzahl und Sensorredundanz, und ähnliches.

Zu Dokumentationszwecken können dann auch alle relevanten Daten geeignet zuordenbar gespeichert werden. Dies kann auch im Hinblick auf rechtliche Überlegungen (Betriebserlaubnis, Versicherungsschutz, forensischer Nachweis etc.) relevant werden. Gespeichert werden insbesondere im Schritt 14 ermittelte Kennwerte, womöglich auch im Schritt 11 eingeholte Kartendaten und/oder im Schritt 12 eingeholte Parameterdaten und womöglich auch einzelne Schritte einer Simulation bzw. eines Simulationsteils.

Der zu simulierende Verkehr in der betrachteten Umgebung kann nach Maßgabe realer Beobachtungen generiert werden. Relevant ist hierbei die Anzahl der Fahrzeuge und Personen in der Umgebung, ihre Nutzungshäufigkeit, Trajektorien, Fehlererscheinungen und ähnliches. Zur Verkehrssimulation können simulierte Aufträge generiert werden, die wiederum zu simulierten Fahrten führen. Die simulierten Aufträge können aus einem Katalog von Mustersimulationsaufträgen entnommen werden. Sie können gegebenenfalls statistisch variiert werden. Entsprechend den simulierten Aufträgen werden dann Fahrten zur Erledigung der Aufträge in der Umgebung simuliert. Insoweit kann eine simulierte Fahrt eine Fahrstrecke eines automatisch navigierbaren Fahrzeugs von der Einfahrt des Fahrzeugs in die betrachtete Umgebung bis zur Ausfahrt des Fahrzeugs aus der Umgebung umfassen. Die simulierten Aufträge bzw. Fahrten werden so gesetzt, dass empirisch ermittelte Werte oder prognostizierte Werte eingehalten sind. Dies kann auch statistische Schwankungen umfassen und determinierte Schwankungen, etwa unterschiedliche Verkehrsdichten abhängig von der Tageszeit (nachts, Mittagspause, ...). Die Simulation umfasst nicht nur die Simulation der automatisch navigierenden Fahrzeuge, sondern auch die Simulation fahrergeführter Fahrzeuge und von Personen. Auch letztere werden möglichst realitätsnah in die Simulation eingeführt.

Insoweit können auch die Erzeugung und/oder die Abänderung eines virtuellen Auftrags ein zu zählendes Ereignis von Interesse sein, da diese den Verkehr charakterisieren. Eine Auftragsänderung kann sich etwa wegen Stau oder Unzugänglichkeit gewisser Umgebungsbereiche ergeben. Auch solche Planänderungen können als Ereignis von Interesse verstanden und gezählt werden.

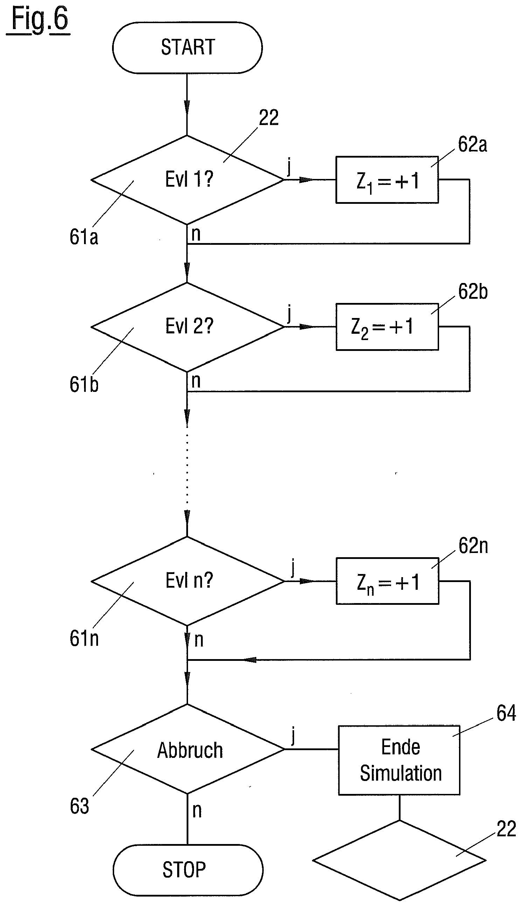

Fig. 6 zeigt schematisch das Erfassen von Ereignissen von Interesse und das Zählen derselben. Es wird angenommen, dass n unterschiedliche Arten von Ereignissen von Interesse ("Evl") überprüft werden, also Evl1, Evl2, ... Evln. Diese Ereignisse werden in einer Reihe von Abfragen 61a, 61b, ... 61n jeweils einzeln überprüft. Jeder einzelnen Überprüfung können komplexere Auswertungen vorausgehen, etwa Kollisionsüberprüfung Fahrzeug-Mensch oder Fahrzeug-Sache, Schutz/Warnfeldverletzung, Geschwindigkeitsüberprüfung und ähnliches. Für jede Art von Ereignissen von Interesse wird ein eigener Zähler Z geführt (also in Schritten 62a, 62b, ... 62n Zähler Z₁, Z₂, ... Zₙ). Wenn das jeweils zugeordnete Ereignis erkannt wurde ("Ja" in Abfrage 61), wird der zugehörige Zähler im Schritt 62 inkrementiert. Wenn alle interessierenden Ereignisse abgefragt sind, endet das dargestellte Verfahren.

Das Verfahren der Fig. 6 kann nach jedem einzelnen Simulationsschritt oder nach jeweils mehreren einzelnen Simulationsschritten (z. B. simuliert jede Sekunde) vorgenommen werden. Da das Vorliegen eines Ereignisses von Interesse nicht notwendigerweise ein anderes ausschließt, wird, soweit dieser Nicht-Ausschluss der Fall ist, der Fluss nach der Inkrementierung eines Zählers zurück in den Abfragefluss geführt. Andernfalls können ausgeschlossene Abfragen übersprungen werden oder zum Ende des Verfahrens übersprungen werden. Wenn nur eine Art von Ereignissen von Interesse definiert ist, weist das Verfahren dementsprechend nur eine Abfrage auf.

Am Ende der Abfragesequenz 61a bis 61n kann eine weitere Abfrage 63 auf ein Abbruchkriterium hin erfolgen. Sie ist eine andere als die Abfrage 22 in Fig. 2. Letztere fragt, ob eine weitere Simulation vorzunehmen ist oder nicht, während Abfrage 63 in Fig. 6 überprüft, ob eine bestimmte gerade laufende Simulation (Simulationsteil) abzubrechen ist. Die Abfrage 63 kann beispielsweise die verschiedenen Zählerstände auswerten und/oder kann simulierte oder reale Laufzeiten der Simulation betrachten. Wenn eines dieser Kriterien den Abbruch einer Simulation ergibt, wird die konkrete Simulation abgebrochen und administrativ beendet (Schritt 64, etwa Datenspeicherung und ähnliches). Danach kann zum Schritt 22 der Fig. 2 gesprungen werden. Wenn die Simulation dagegen nicht abgebrochen werden soll ("Nein" in 63), wird die Simulation mit einem weiteren Simulationsschritt fortgesetzt.

Soweit abstrakte Kennwerte zur Beschreibung einer automatisch befahrbaren Umgebung als Kennwerte ermittelt werden, können diese aus einem einzigen der Zählwerte hergestellt werden, etwa aus einem Zählwert betreffend Personenschaden, oder aus mehreren ausgewählten, etwa Zählwerten zu Personenschaden und Sachschäden, gegebenenfalls auch zu kritischen Situationen. Allgemein gesprochen können mehrere Zählerstände zu mehreren Arten von Ereignissen von Interesse miteinander verrechnet werden, insbesondere addiert werden, wobei die Addition gewichtet erfolgen kann. Ein Zählwert zu Personenschaden kann ein hohes Gewicht haben, ein Zählwert zu Sachschäden ein geringeres Gewicht etc.

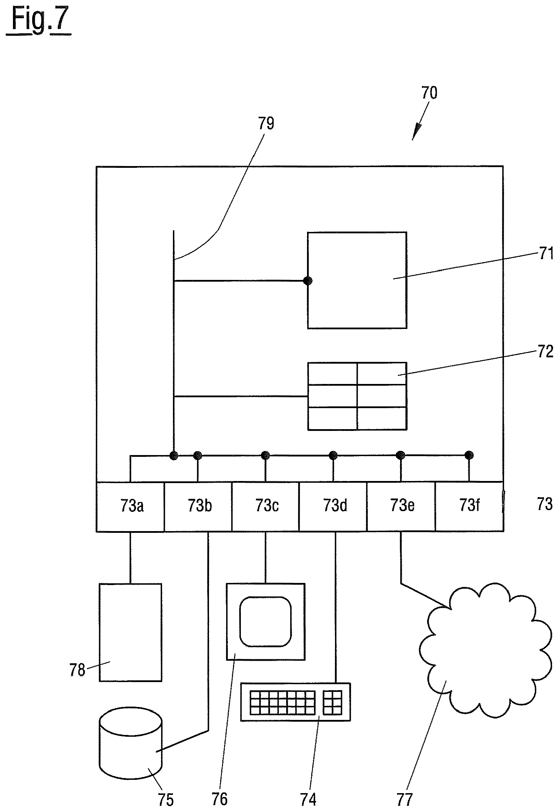

Eine Vorrichtung 70 zur Durchführung des Verfahrens ist in Figur 7 schematisch gezeigt. Sie kann einen Rechner oder (nicht gezeigt) ein Rechnernetz aufweisen, das die nötigen Schritte vornimmt und implementiert. Es kann Verbindungen bzw. Schnittstellen 73 zu den nötigen Datenquellen (etwa Vorrichtung 78 mit Schnittstelle 73a mit Kartendaten) haben, soweit sie nicht intern vorhanden sind, und kann auch Eingabeeinrichtungen, z. B. Tastatur 74 mit Schnittstelle 73d oder externe Speicheranbindung 75 mit Schnittstelle 73b für externe Eingaben, etwa für die Parametersätze, aufweisen. Ein Bildschirm 76 mit Schnittstelle 73e kann vorgesehen sein.

Die Simulation selbst und die Erfassung und Zählung von Ereignissen von Interesse und die Ermittlung der Kennwerte/Fahrzeugparameter können in einer oder mehreren Einrichtungen 71 (Recheneinheiten) erfolgen. Die Vorrichtung kann auch leitungsgebundene oder drahtlose Schnittstellen 73e, 73f zum einholen oder Ausgeben von Daten über Netzwerke, etwa das Internet 77, aufweisen. Sie weist einen internen Speicher 72 mit unterschiedlichen Bereichen (fest, flüchtig, Daten, Programme) auf. Die interne Verbindungen erfolgt mit einem Bus 79 oder ähnlichem, soweit ein einzelner Rechner betroffen ist, ansonsten (nicht gezeigt) bspw. über LAN oder wLAN oder ähnliches.

Gegenstand der Erfindung ist auch ein Datenträger mit Daten darauf, die ausführbaren Code repräsentieren, der, wenn er ausgeführt wird, das beschriebene Verfahren implementiert.

Wie schon gesagt sollen die oben beschriebenen Merkmale auch auf und für die Bewegung eines Roboters oder Roboterarms als Fahrzeug in seiner Umgebung anwendbar verstanden werden. Sie können aber auch enger nur auf die Situation von automatisch fahrenden Fahrzeugen in einer Umgebung, etwa einem Lager, anwendbar verstanden werden.

In der vorliegenden Beschreibung sollen Merkmale auch dann als miteinander kombinierbar verstanden werden, wenn ihre Kombination nicht ausdrücklich beschrieben ist, soweit die Kombination technisch möglich ist. Merkmale, die in einem gewissen Kontext oder in einer Figur oder in einem Patentanspruch oder in einer Ausführungsform beschrieben sind, sollen auch aus diesem Kontext, dieser Figur, diesem Patentanspruch oder dieser Ausführungsform lösbar verstanden werden und mit anderen Kontexten, Figuren, Patentansprüchen oder Ausführungsformen kombinierbar verstanden werden, soweit die Kombination technisch möglich ist. Beschreibungen von Verfahrensschritten sollen auch als Beschreibung des damit hergestellten Produkts verstanden werden, und umgekehrt.

### Bezugszeichenliste

- 11: Bereitstellen von Kartendaten
- 12: Bereitstellen von Parameterdaten
- 13: Simulation, Erkennung, Zählung
- 14: Kennwertermittlung
- 15: Ausgabe, Speicherung
- 21: Simulationsteil
- 22: Abbruchabfrage
- 23: Parameteränderung
- 30: stationärer Rechner
- 31a-c: Personen
- 32a-d: automatisch navigierendes Fahrzeug
- 33: fahrergeführtes Fahrzeug
- 34a-d: Regale
- 35: Freilager
- 36: Befahrbarer Bereich
- 37a,b: Tor
- 38a,b: Tür
- 39: stationäre Navigationshilfen
- 41: Fahrzeugkörper
- 42: Räder
- 43: Steuerung
- 44: Antrieb
- 45: Bremsen
- 46a-d: Sensoren
- 47: Kommunikationsschnittstelle
- 51: Schutzfeld
- 51a-d: Eckpunkte
- 52-53: Warnfelder
- 61a-n: Abfragen
- 62a-n: Inkrementierungen
- 63: Abbruchabfrage

## Patentansprüche

1. Verfahren zur Ermittlung eines oder mehrerer Fahrzeugparameter für ein autonom fahrendes Fahrzeug für eine automatisch mit autonom fahrenden Fahrzeugen befahrbare Umgebung mit den Schritten
• Bereitstellen (11) einer ortsauflösenden, elektronisch nützbaren Repräsentation der autonom befahrbaren Umgebung,
• Bereitstellen (12) von Verkehrsparametern, die summarische Eigenschaften des zu simulierenden Verkehrs in der autonom befahrbaren Umgebung beschreiben,
• Bereitstellen (12) von Fahrzeugparametern, die Eigenschaften von Fahrzeugen in der autonom befahrbaren Umgebung beschreiben,
• Simulieren des (13) Verkehrs in der Umgebung Bezug nehmend auf die elektronisch nützbare Repräsentation der autonom befahrbaren Umgebung und Bezug nehmend auf die bereitgestellten Verkehrsparameter und Fahrzeugparameter,
mit den kennzeichnenden Schritten
• In der Simulation Erfassen (61a-n) von Ereignissen von Interesse und Zählen (62a-n) derselben,
• Ermitteln (14) des bzw. der Fahrzeugparameter Bezug nehmend auf das Zählergebnis, und
• Ausgeben und/oder Speichern (15) des bzw. der Fahrzeugparameter.

2. Verfahren nach Anspruch 1, bei dem der oder die Fahrzeugparameter die Definition (51a-d) eines oder mehrerer Schutz- und/oder Warnfelder (51, 52, 53) um das Fahrzeug herum umfassen.

3. Verfahren nach Anspruch 2, bei dem die Fahrzeugparamater Ausstattungsparameter des Fahrzeugs umfassen, etwa Steuerungsparameter wie Höchstgeschwindigkeiten und Beschleunigungen, und/oder Hardwareparameter wie Hardwarequalität, Hardwareanzahl und Hardwareredundanz, insbesondere zu Sensoren.

4. Verfahren nach einem der vorherigen Ansprüche, bei dem eine oder mehrere Änderungen der elektronisch nützbaren Repräsentation der Umgebung als Kennwerte ermittelt und ausgegeben und/oder gespeichert werden.

5. Verfahren nach einem der vorherigen Ansprüche, bei dem die Fahrzeugparameter einen oder mehrere der folgenden Parameter umfassen können:
• Ausstattungsparameter eines Fahrzeugs, insbesondere einen oder mehrere aus
∘ Sensorikeigenschaften, ggf. mit Sensorikfehlerwahrscheinlichkeiten,
∘ Aktorikeigenschaften, ggf. mit Aktorikfehlerwahrscheinlichkeiten,
∘ Steuerungseigenschaften, ggf. mit Steuerungsfehlerwahrscheinlichkeiten,
∘ Kommunikationseigenschaften, ggf. mit Kommunikationsfehlerwahrscheinlichkeiten,
• Dynamikparameter eines Fahrzeugs, insbesondere einen oder mehrere aus
∘ Geschwindigkeitswerte,
∘ Beschleunigungswerte,
∘ Abstandswerte,
∘ Schutzfelder,
∘ Warnfelder;
und bei dem die summarischen Verkehrsparameter einen oder mehrere der folgenden Parameter umfassen können:
• Arten und jeweilige Anzahl der automatisch fahrenden Fahrzeuge in der Umgebung, ggf. mit statistischen und determinierten Schwankungen,
• Anzahl von nicht automatisch fahrenden Fahrzeugen und/oder Fußgängern in der Umgebung, ggf. mit statistischen und determinierten Schwankungen,
• Vorzugsrichtungen und/oder Vorzugspfade und/oder Vorzugsorte der Fahrzeuge und/oder Fußgänger, ggf. mit statistischen und determinierten Schwankungen,
• Betriebsfehlerwahrscheinlichkeit (Ladung fällt runter),
• Kartenfehlerwahrscheinlichkeit,
• Ausstattung der Umgebung mit aktiven und/oder passiven Navigationshilfen,
wobei insbesondere wenigstens ein Teil der summarischen Verkehrsparameter entsprechend realen Beobachtungen in der realen Umgebung gesetzt sind, insbesondere einer oder mehrere von
• Fahrzeugarten und deren jeweilige Parameter,
• Anzahl der Fahrzeuge, ggf über der Zeit,
• Vorzugspfade und/oder -orte,
• untypische Fahrten

6. Verfahren nach einem der vorherigen Ansprüche, bei dem nach einem ersten Simulationsteil mit einem ersten Fahrzeugparametersatz dessen Zählwerte gespeichert werden und ein zweiter Simulationsteil mit einem zweiten Fahrzeugparametersatz mit getrennter Ereigniszählung durchgeführt wird, wobei im zweiten Fahrzeugparametersatz einer oder mehrere der Fahrzeugparameter gegenüber denen im ersten Satz verändert sind, wobei nach dem zweiten Simulationsteil auch dessen Zählwerte gespeichert werden, und wobei der bzw. die Fahrzeugparameter Bezug nehmend auf die gespeicherten Zählwerte der Simulationsteile ermittelt wird.

7. Verfahren nach einem der vorherigen Ansprüche, bei dem nach einem ersten Simulationsteil dessen Zählwerte gespeichert werden und ein zweiter Simulationsteil auf der Grundlage einer geänderten elektronisch nützbaren Repräsentation der Umgebung mit getrennter Ereigniszählung durchgeführt wird, wobei nach dem zweiten Simulationsteil auch dessen Zählwerte gespeichert werden, und wobei ein Kennwert Bezug nehmend auf die gespeicherten Zählwerte der Simulationsteile ermittelt und ausgegeben und/oder gespeichert wird.

8. Verfahren nach Anspruch 6 oder 7, bei dem die Veränderung der Fahrzeugparameter und/oder der elektronisch nützbaren Repräsentation automatisch, vorzugsweise nach Maßgabe der schon vorhandenen Zählwerte, oder von extern über eine Eingabeschnittstelle erfolgt.

9. Verfahren nach einem der vorherigen Ansprüche,
bei dem nach einer Simulation oder nach einem Simulationsteil die zugrunde liegenden Parameter den zugehörigen Zählwerten zuordenbar gespeichert werden, und/oder
bei dem die Simulation beendet wird, wenn ein Zählwert eine bestimmte Schwelle überschritten hat oder wenn die Simulation eine bestimmte Zeitdauer simuliert hat, und/oder
bei dem mehrere Arten interessierender Ereignisse definiert sind und die Zählung der interessierenden Ereignisse getrennt für jede der Arten erfolgt, wobei insbesondere die Ereignisse von Interesse eine oder mehrere der folgenden Arten aufweisen:
• unbehinderter Verkehr
• zähfließender Verkehr
• Stau
• Auftragserstellung
• Auftragsänderung
• kritische Situation/Fast-Schaden
• Schutz/Warnfeldverletzung
• Entstehung von Quetschstellen,
• Sachschaden/Fahrzeugschaden
• Personenschaden.

10. Verfahren nach einem der vorherigen Ansprüche, bei dem das Zählen von Ereignissen von Interesse ereignisgesteuert oder zeitgesteuert oder fahrweggesteuert oder positionsgesteuert erfolgt, und/oder bei dem die Zählung interessierender Ereignisse für ein einzelnes simuliertes Fahrzeug oder unterscheidbar für mehrere oder alle simulierte Fahrzeuge oder global für mehrere oder alle simulierte Fahrzeuge vorgenommen wird, und/oder bei dem das Erfassen und das Zählen von Ereignissen von Interesse und die Fahrzeugparameterermittlung ortsauflösend erfolgt, und/oder bei dem in der Simulation auch fahrergeführte Fahrzeuge und/oder Fußgänger anhand jeweiliger Parametersätze simuliert werden.

11. Verfahren nach einem der vorherigen Ansprüche, bei dem die Simulation das automatische Erzeugen simulierter Fahraufträgen und die simulierte Durchführung der beauftragten Fahrten umfasst, wobei insbesondere das automatische Erzeugen von simulierten Fahraufträgen auf vordefinierte simulierte Fahraufträge Bezug nimmt und Bezug nehmend auf reale Beobachtungen erfolgt.

12. Verfahren nach einem der vorherigen Ansprüche,
bei dem in einer Simulation oder in einem Simulationsteil statische Objekte in der Umgebung erzeugt und ggf. wieder entfernt werden, und/oder
bei dem das Erfassen und Zählen von Ereignissen von Interesse während der Simulation erfolgt, und/oder bei dem die Simulation von einem definierten Anfangszustand ausgeht, diesen in einem Simulationsschritt nach Maßgabe der elektronisch nützbaren Repräsentation und der bereitgestellten Parameter über eine definierte Zeitspane zu einem Endzustand weiterrechnet, und für einen weiteren Simulationsschritt den errechneten Endzustand als neuen Anfangszustand nimmt, und/oder
bei dem die ermittelten Fahrzeugparameter und Simulationsparameter und ggf. auch Zwischenergebnisse einzelne Simulationsschritte einander zuordenbar gespeichert werden.

13. Verfahren nach einem der vorherigen Ansprüche, wobei
ein Warnfeld ein relativ zum simulierten Fahrzeug definierter Bereich der simulierten Fahrzeugumgebung ist und eine Warnfeldverletzung die in der Simulation erkannte simulierte ungeplante Anwesenheit eines simulierten Objekts im Warnfeld ist, und
für die Simulation bereitgestellte und bei der Simulation berücksichtigte Fahrzeugparameter
• Sensorikeigenschaften eines Fahrzeugsensors, ggf. mit Sensorikfehlerwahrscheinlichkeiten, und/oder
• Aktorikeigenschaften eines Fahrzeugaktors, ggf. mit Aktorikfehlerwahrscheinlichkeiten und/oder
• Steuerungseigenschaften einer Fahrzeugsteuerung, ggf. mit Steuerungsfehlerwahrscheinlichkeiten
umfassen.

14. Vorrichtung (70) zur Durchführung des Verfahrens nach einem der vorherigen Ansprüche.

15. Datenträger mit Daten darauf, die lauffähige Software und Parameter hierfür darstellen, wobei die Software, wenn sie ausgeführt wird, ein Verfahren nach einem der Ansprüche 1 bis 13 ausführt.

## Claims

1. A method of determining one or more vehicle parameters for an autonomously traveling vehicle for an environment automatically trafficable by autonomously traveling vehicles comprising the steps
• providing (11) a spatially resolving, electronically usable representation of the autonomously trafficable environment;
• providing (12) traffic parameters which describe summary properties of the traffic to be simulated in the autonomously trafficable environment;
• providing (12) vehicle parameters which describe properties of vehicles in the autonomously trafficable environment;
• simulating (13) the traffic in the environment with reference to the electronically usable representation of the autonomously trafficable environment and with reference to the traffic parameters and vehicle parameters provided, comprising the characterizing steps
• in the simulation, detecting (61a-n) events of interest and counting (62an) the same;
• determining (14) the vehicle parameter or vehicle parameters with reference to the count result; and
• outputting and/or storing (15) the vehicle parameter or vehicle parameters.

2. A method according to claim 1, in which the vehicle parameter or vehicle parameters comprise defining (51a-d) one or more protected and/or warning fields (51, 52, 53) around the vehicle.

3. A method according to claim 2, in which the vehicle parameters comprise equipment parameters of the vehicle, for instance control parameters such as top speeds and accelerations, and/or hardware parameters such as hardware quality, hardware number and hardware redundancy, in particular with respect to sensors.

4. A method according to any one of the preceding claims, in which one or more changes of the electronically usable representation of the environment are determined and output and/or stored as characteristic values.

5. A method according to any one of the preceding claims, in which the vehicle parameters can comprise one or more of the following parameters:
• equipment parameters of a vehicle, in particular one or more of
∘ sensor system properties, optionally with sensor system defect probabilities;
∘ actuator system properties, optionally with actuator system defect probabilities;
∘ control properties, optionally with control defect probabilities;
∘ communication properties, optionally with communication defect probabilities;
• dynamic parameters of a vehicle, in particular one or more of
∘ speed values;
∘ acceleration values;
∘ distance values;
∘ protected fields:
∘ warning fields;
and in which the summary vehicle parameters can comprise one or more of the following parameters:
• kinds and respective number of the automated guided vehicles in the environment, optionally with statistical and determined fluctuations;
• number of non-automated guided vehicles and/or pedestrians in the environment, optionally with statistical and determined fluctuations;
• preferred directions and/or preferred paths and/or preferred locations of the vehicles and/or pedestrians, optionally with statistical and determined fluctuations;
• operating error probability (load falls off);
• map error probability; and
• equipping the environment with active and/or passive navigation aids, wherein in particular at least some of the summary traffic parameters are set in accordance with real observations in the real environment, in particular one or more of
• vehicle kinds and their respective parameters;
• number of vehicles, optionally over time;
• preferred paths and/or locations; and
• atypical trips.

6. A method according to any one of the preceding claims, in which after a first simulation part having a first vehicle parameter set its count values are stored and a second simulation part having a second vehicle parameter set is carried out with a separate event counting, wherein one or more of the vehicle parameters in the second vehicle parameter set are changed with respect to those in the first set, wherein after the second simulation part its count values are also stored, and wherein the vehicle parameter or vehicle parameters are determined with reference to the stored count values of the simulation parts.

7. A method according to any one of the preceding claims, in which after a first simulation part its count values are stored and a second simulation part is carried out on the basis of a changed electronically usable representation of the environment with a separate event counting, wherein after the second simulation part its count values are also stored, and wherein a characteristic value is determined with reference to the stored count values of the simulation parts and is output and/or stored.

8. A method according to claim 6 or 7, in which the change of the vehicle parameters and/or of the electronically usable representation takes place automatically, preferably in accordance with the already present count values, or takes place externally via an input interface.

9. A method according to any one of the preceding claims,
in which after a simulation or after a simulation part the underlying parameters are stored in a manner associable with the associated count values, and/or
in which the simulation is ended when a count value has exceeded a specific threshold or when the simulation has simulated a specific time duration, and/or
in which a plurality of kinds of events of interest are defined and the counting of the events of interest takes place separately for each of the kinds, wherein in particular the events of interest have one or more of the following kinds:
• freely moving traffic;
• slow-moving traffic;
• traffic jam;
• job preparation;
• job change;
• critical situation/near miss;
• protected/warning field infringement;
• arising of crushing points;
• property damage/vehicle damage; and
• injury to a person.

10. A method according to any one of the preceding claims, in which the counting of events of interest takes place in an event-controlled or time-controlled or route-controlled or position-controlled manner, and/or in which the counting of events of interest is carried out for a single simulated vehicle or distinguishably for a plurality or for all of the simulated vehicles or globally for a plurality or for all of the simulated vehicles, and/or in which the detection and the counting of events of interest and the vehicle parameter determination take place in a spatially resolving manner, and/or in which operator-driven vehicles and/or pedestrians are also simulated with reference to respective parameter sets in the simulation.

11. A method according to any one of the preceding claims, in which the simulation comprises the automatic generation of simulated trip jobs and the simulated carrying out of the commissioned trips, wherein in particular the automatic generation of simulated trip jobs references predefined simulated trip jobs and takes place with reference to real observations.

12. A method according to any one of the preceding claims,
in which static objects are produced in the environment and are optionally removed again in a simulation or in a simulation part, and/or
in which the detection and the counting of events of interest takes place during the simulation, and/or in which the simulation starts from a defined starting state; further calculates it in a simulation step in accordance with the electronically usable representation and with the parameters provided over a defined time length to form an end state; and takes the calculated end state as the new starting state for a further simulation step, and/or in which the determined vehicle parameters and simulation parameters and optionally also intermediate results of individual simulation steps are stored in a manner associable with one another.

13. A method according to any one of the preceding claims, wherein
a warning field is a region of the simulated vehicle environment defined relative to the simulated vehicle and a warning field infringement is the simulated unplanned presence of a simulated object in the warning field that is recognized in the simulation, and
vehicle parameters provided for the simulation and considered in the simulation comprise
• sensor system properties of a vehicle sensor, optionally with sensor system defect probabilities, and/or
• actuator system properties of a vehicle actuator, optionally with actuator system defect probabilities, and/or
• control properties of a vehicle control, optionally with control defect probabilities.

14. An apparatus (70) for performing the method according to any one of the preceding claims.

15. A data carrier having data thereon which represent executable software and parameters therefor, wherein the software, when executed, executes a method according to any one of the claims 1 to 13.

## Revendications

1. Procédé pour déterminer un ou plusieurs paramètres d'un véhicule, circulant de façon autonome, pour un environnement susceptible d'être parcouru automatiquement par des véhicules circulant de façon autonome, comprenant les étapes consistant à :
• fournir (11) une représentation à résolution spatiale et exploitable électroniquement de l'environnement à parcourir de façon autonome,
• fournir (12) des paramètres de trafic qui décrivent des propriétés sommaires du trafic à simuler dans l'environnement à parcourir de façon autonome,
• fournir (12) des paramètres de véhicule qui décrivent des propriétés de véhicules dans l'environnement à parcourir de façon autonome,
• simuler (13) le trafic dans l'environnement en se référant à la représentation exploitable électroniquement de l'environnement à parcourir de façon autonome et en se référant aux paramètres de trafic et aux paramètres de véhicule fournis,
et comprenant les étapes caractérisant, consistant à :
• lors de la simulation, détecter (61a-n) des événements d'intérêt et les compter (62a-n),
• déterminer (14) le ou les paramètres de véhicule en se référant au résultat du comptage, et
• émettre et/ou stocker (15) le ou les paramètres de véhicule.

2. Procédé selon la revendication 1,
dans lequel
le ou les paramètres de véhicule incluent la définition (51a-d) d'un ou de plusieurs champs de protection et/ou d'avertissement (51, 52, 53) autour du véhicule.

3. Procédé selon la revendication 2,
dans lequel
les paramètres de véhicule incluent des paramètres d'équipement du véhicule, par exemple des paramètres de commande tels que des vitesses maximales et des accélérations, et/ou des paramètres de matériels tels que la qualité de matériels, le nombre de matériels et la redondance de matériels, en particulier par rapport à des capteurs.

4. Procédé selon l'une des revendications précédentes,
dans lequel une ou plusieurs modifications de la représentation exploitable électroniquement de l'environnement sont déterminées et émises et/ou stockées comme étant des valeurs caractéristiques.

5. Procédé selon l'une des revendications précédentes,
dans lequel les paramètres de véhicule peuvent inclure un ou plusieurs des paramètres suivants :
• des paramètres d'équipement d'un véhicule, en particulier un ou plusieurs paramètres parmi
∘ les propriétés de capteur, le cas échéant avec des probabilités d'erreur de capteur, et/ou
∘ les propriétés d'actionneur, le cas échéant avec des probabilités d'erreur d'actionneur, et/ou
∘ les propriétés de commande, le cas échéant avec des probabilités d'erreur de commande,
∘ les propriétés de communication, le cas échéant avec des probabilités d'erreur de communication,
• des paramètres dynamiques d'un véhicule, en particulier un ou plusieurs paramètres parmi
∘ les valeurs de vitesse,
∘ les valeurs d'accélération,
∘ les valeurs de distance,
∘ les champs de protection,
∘ les champs d'avertissement ;
et dans lequel les paramètres de trafic sommaires peuvent inclure un ou plusieurs des paramètres suivants :
• les types et le nombre respectif des véhicules circulant automatiquement dans l'environnement, le cas échéant avec des variations statistiques et déterminées,
• le nombre de véhicules ne circulant pas automatiquement et/ou de piétons dans l'environnement, le cas échéant avec des variations statistiques et déterminées,
• les directions préférentielles et/ou les chemins préférentiels et/ou les lieux préférentiels des véhicules et/ou des piétons, le cas échéant avec des variations statistiques et déterminées,
• la probabilité d'erreur de fonctionnement (une charge qui tombe),
• la probabilité d'erreur de carte,
• l'équipement de l'environnement avec des aides à la navigation actives et/ou passives,
dans lequel, en particulier, au moins une partie des paramètres de trafic sommaires sont fixés en fonction d'observations réelles dans l'environnement réel, en particulier un ou plusieurs paramètres parmi
• les types de véhicules et leurs paramètres respectifs,
• le nombre de véhicules, le cas échéant en fonction du temps,
• les chemins et/ou lieux préférentiels,
• les déplacements atypiques.

6. Procédé selon l'une des revendications précédentes,
dans lequel, après une première partie de simulation avec un premier jeu de paramètres de véhicule, ses valeurs de comptage sont stockées, et une deuxième partie de simulation avec un deuxième jeu de paramètres de véhicule est effectuée avec un comptage d'événement séparé, un ou plusieurs desdits paramètres de véhicule étant modifiés dans le deuxième jeu de paramètres de véhicule par rapport à ceux dans le premier jeu, et, après la deuxième partie de simulation, également ses valeurs de comptage sont stockées, et le ou les paramètres de véhicule sont déterminés en se référant aux valeurs de comptage stockées desdites parties de simulation.

7. Procédé selon l'une des revendications précédentes,
dans lequel, après une première partie de simulation, ses valeurs de comptage sont stockées, et une deuxième partie de simulation est effectuée sur la base d'une représentation de l'environnement exploitable électroniquement modifiée, avec un comptage séparé des événements,
après la deuxième partie de simulation, également ses valeurs de comptage sont stockées, et
une valeur caractéristique est déterminée et émise et/ou stockée en se référant aux valeurs de comptage stockées des parties de simulation.

8. Procédé selon la revendication 6 ou 7,
dans lequel la modification des paramètres de véhicule et/ou de la représentation exploitable électroniquement s'effectue automatiquement, de préférence en fonction des valeurs de comptage déjà existantes, ou de l'extérieur via une interface d'entrée.

9. Procédé selon l'une des revendications précédentes,
dans lequel, après une simulation ou après une partie de simulation, les paramètres sous-jacents sont stockés de manière à pouvoir être associés aux valeurs de comptage correspondantes, et/ou
la simulation est arrêtée lorsqu'une valeur de comptage a dépassé un certain seuil ou lorsque la simulation a simulé une certaine durée de temps, et/ou
dans lequel plusieurs types d'événements d'intérêt sont définis et le comptage des événements d'intérêt s'effectue séparément pour chacun desdits types, en particulier, les événements d'intérêt incluant un ou plusieurs des types suivants :
• trafic non perturbé
• trafic lent
• embouteillage
• création d'un ordre
• modification d'un ordre
• situation critique/quasi-dommage
• violation d'un champ de protection/avertissement
• apparition de points d'écrasement,
• dommages matériels/dommages au véhicule
• dommages corporels.

10. Procédé selon l'une des revendications précédentes,
dans lequel le comptage des événements d'intérêt est effectué en étant commandé par les événements ou par le temps ou par la trajectoire ou par la position, et/ou
le comptage des événements d'intérêt est effectué pour un seul véhicule simulé ou de manière différenciée pour plusieurs ou tous les véhicules simulés ou globalement pour plusieurs ou tous les véhicules simulés, et/ou
la détection et le comptage des événements d'intérêt et la détermination de paramètres de véhicule s'effectuent avec une résolution spatiale, et/ou
lors de la simulation, également des véhicules dirigés par un conducteur et/ou des piétons sont simulés à l'aide de jeux de paramètres respectifs.

11. Procédé selon l'une des revendications précédentes,
dans lequel la simulation inclut la génération automatique d'ordres de déplacement simulés et l'exécution simulée des déplacements ordonnés, en particulier, la génération automatique d'ordres de déplacement simulés se réfère à des ordres de déplacement simulés prédéfinis et s'effectue en se référant à des observations réelles.

12. Procédé selon l'une des revendications précédentes,
dans lequel, lors d'une simulation ou lors d'une partie de simulation, des objets statiques dans l'environnement sont créés et, le cas échéant, enlevés, et/ou
la détection et le comptage des événements d'intérêt s'effectuent pendant la simulation, et/ou
la simulation part d'un état initial défini, le prend en compte sur une période de temps définie, lors d'une étape de simulation, pour calculer un état final en fonction de la représentation exploitable électroniquement et en fonction des paramètres fournis, et prend l'état final calculé comme nouvel état initial pour une autre étape de simulation, et/ou
les paramètres de véhicule déterminés et les paramètres de simulation déterminés et, le cas échéant, également les résultats intermédiaires des différentes étapes de simulation sont stockés de manière à pouvoir être associés les uns aux autres.

13. Procédé selon l'une des revendications précédentes,
dans lequel un champ d'avertissement est une zone de l'environnement simulé du véhicule, laquelle est définie par rapport au véhicule simulé, et une violation du champ d'avertissement est la présence imprévue, simulée, reconnue lors de la simulation, d'un objet simulé dans le champ d'avertissement, et
les paramètres de véhicule fournis pour la simulation et pris en compte lors de la simulation incluent
• des propriétés de capteur d'un capteur du véhicule, le cas échéant avec des probabilités d'erreur de capteur, et/ou
• des propriétés d'actionneur d'un actionneur du véhicule, le cas échéant avec des probabilités d'erreur d'actionneur, et/ou
• des propriétés de commande d'une commande de véhicule, le cas échéant avec des probabilités d'erreur de commande.

14. Dispositif (70) de mise en oeuvre du procédé selon l'une des revendications précédentes.

15. Support de données sur lequel se trouvent des données représentant un logiciel exécutable et des paramètres pour celui-ci, dans lequel le logiciel, lorsqu'il est exécuté, exécute un procédé selon l'une des revendications 1 à 13.
